# EUROPEAN PATENT APPLICATION

(11) **EP 2 905 972 A2**
(43) Date of publication of application: **12.08.2015**
(21) Application number: 14197457.6
(22) Date of filing: 11.12.2014
(51) Int. Cl.: H04R 1/10, G06T 7/00, H04R 3/04

(54) **System and method for producing a personalized earphone**

(30) Priority: 16.01.2014 US 201461927990 P
(71) Applicant: Jobani, Itamar, San Diego, CA 92103 (US)
(72) Inventor: Jobani, Itamar, San Diego, CA 92103 (US)
(74) Representative: Sun, Yiming

(57) **Abstract**

This disclosure relates to a system and method for producing a personalized earphone unit forming a comfort fit with ears of a user. The system comprises a mobile application installed in an electronic communication device and/or a website accessible by any networkable device for capturing images and video of the ears of the user. The images and video may be examined automatically using the mobile application and/or the website, and the video and/or images are uploaded to a server. The server stores and processes the images and video and sends them to a three dimensional printer unit for generating the personalized earphone unit. Audio electronic components are added to the personalized earphone unit for creating a functional and custom fit personalized earphone unit for an individual user that fit well into the ears. The system allows sharing and marketing of a plurality of designs and products of the earphone unit.

## Description

### CROSS-REFERENCE TO RELATED APPLICATIONS

This application claims benefit of priority of US Application 61927990 filed on January 16, 2014 entitled "System and Method for Producing A personalized Earphone" owned by the assignee of the present application and herein incorporated by reference in its entirety.

### FIELD OF THE DISCLOSURE

This disclosure relates to a system for producing a personalized earphone unit for an individual, and more particularly to a system and method for producing a personalized earphone unit by capturing a user's ear structure using a mobile communication device, a tablet computer, a personal computer, computer vision technology, a digital ear scanner, a laser scanner, molds, and/or other methods and/or devices for capturing visual data.

### BACKGROUND

Earphones are used by many people for listening to audio. Some of these earphones may function as a microphone when used with a mobile communication device such as a mobile phone. Many people use earphones to listen to music while performing activities such as running, riding, hiking, etc. The majority of these earphones are mass produced and do not consider the size and shape of a user's ear, and hence, do not fit perfectly for everyone. This causes the earphone to fall off and/or out of the ear while performing activities, as well as causing discomfort due to poor fit. A solution to this problem existing today is to use silicon tube shells with the earphones. These silicon tube shells are made available in different sizes such as small, medium, and large. However, this is not an ideal solution because providing only three size/shape choices to the entire population simply does not provide well-fitting earphones for different sized and uniquely shaped ear/ear canals.

Another set of earphone models eliminates the problems caused by the use of silicon tube shells with the in-ear headphones by providing a variety of custom fitted earpieces using a mold. An audiologist would usually take the mold, which involves creating an impression of the ear using silicon. However, these custom made earpieces require users to provide the impression of their ear with the help of audiologists. These custom made earpieces cannot be mass produced as it is difficult for individuals to consult with an audiologist to produce the mold using silicon. These custom made earphones are usually made by hand casting (not mass-produced). Usually, a silicon to acrylic mold is made first, and then scanned. It is a time consuming process that requires professional assistance to the consumer for fitting and molding, and is relatively costly.

Some of the existing types of in-ear earphones are uncomfortable, and they can be inconvenient to put in and remove, which makes them impractical for environments in which the users need to do so often. Finally, most in-ear-earphones, because they are not fitted to the particular user's ears and/or ear canals, cause pain or irritation to the ears after prolonged wear. This pain or irritation can be very distracting, especially if the user is engaged in an activity, such as exercise, sports, and/or active occupations that involve a lot of movement. Additionally, the improper fit causes some earphones to fall off of user's ears during activity. The methods available today which allow individual users to design and build headphones based on the respective size and shape of their ears easily are not simple, require an expert's assistance (e.g., an audiologist), are expensive, and require a large amount of time to create (e.g., creating a mold). Thus, there exists a need for an improved system and method of producing a customized earphone unit, which fits into the ears of individual users.

### SUMMARY

One aspect of the disclosure relates to a system configured to easily obtain the actual size and shape of an individual's ear. The system may be operated by a user without the need to employ a complex method and/or without the need to possess specialized and/or specific technical knowledge. The system may be cost effective, simple, and/or user-friendly, may be easily be set up, and the resulting earphone unit may fit comfortably onto and/or into the ears of the user while he/she is performing different activities. The system may be substantially universally employable for producing earpieces customized to fit with the shape of an individual's ear. In addition, the system may be employed by a user to generate earpieces according their personal preferences such as color, design, ergonomic options, add-on features, etc. In addition, the system may allow users to market, sell, and/or otherwise share their designs.

The system may allow a user to generate earphones that (1) are custom fitted to his/her ear and ear canal, (2) are ergonomically designed to best suit the user's intended use of the earphones based on user inputted data regarding the activities during which he/she may most be wearing the earphones, (3) provide the user with Soundscaping options based on his/her preference, (4) are personalized to the user's aesthetic/style/design preferences, (5) allow the user to select from a wide range of add-on items and capabilities (including, but not limited to, Bluetooth option, built-in microphone, interchangeable skins, digital display, and more), and (6) allow users (e.g., designers) to share, market, and/or sell their designs.

The system may comprise a website (e.g., generated by one or more processors of a server), a mobile application installed in a mobile communication device (e.g., which includes one or more processors), and/or other components that facilitate the capturing of a plurality of images, video, and/or other visual data conveying information related to the ear(s) of a user. The mobile application and/or website may be launched from the electronic communication device, for example. The electronic communication device may include devices such as a smartphone, a tablet computer, personal computer, laptop, desktop, and/or other devices. The electronic communication device may be used to capture a plurality of images and/or a video of the ears of the user using an integrated camera of the electronic communication device and/or any other camera or device capable of capturing visual data (such as computer vision technology, scanners, etc.) that can be connected to a networked device. The plurality of images may be examined automatically via the mobile application and/or website. If the plurality of images and/or the video is sufficient for building a personalized earphone unit (e.g., the sufficiency may be determined by the mobile application and/or website), the plurality of images and/or the video may be uploaded to at least one server. The server may store and/or process the plurality of images, video, and/or other visual data. The images may be processed to create a three dimensional (3D) model of the user scan. Then a 3D model of the user's ear(s) may be created by means of photogrammetry, for example. Next, the desired earpiece(s) may be generated based on the 3D model of the user's ear(s), the user's preferences, and/or other factors. A three dimensional printer unit may communicate with the server. The three dimensional printer unit may receive an electronic file generated from the model of the personalized earphone unit (e.g., by the server). The electronic file may be configured to inform the three dimensional printing unit that fabricates the personalized earphone for the subject. The personalized earphone unit may be generated based on the plurality of images of the ear(s) of the user processed by and received from the server, and/or other information. A plurality of audio electronic components may be added to the personalized earphone unit model for creating a fully working and/or custom made personalized earphone unit for individual users.

A user may access the application via (a graphical user interface of) a website and/or by downloading the mobile application to their mobile communication device, and/or by other methods. In some implementations, the plurality of images of the ear(s) and/or other visual data may be captured in the presence of a reference object placed near the ears of the user. The reference object may help in analyzing the size of the ears of the user. During the process of scanning and/or capturing the images and/or video of the ear(s), an easily found household item, such as a coin, and/or a QR code in a mobile screen (and/or other items) may be placed near the ear. When performing the scan (e.g., taking photos, video, etc.), the reference object may be used as a measurement reference when processing the scale of the model of the ear(s). The screen of the communication device (e.g., the mobile phone and/or tablet) may also be used as a scale reference to the scanned model. This may be done by using a mirror and/or using the front camera to take a photo of both the ear and the screen of the phone, by using another camera, and/or by other methods. The visual data (e.g., images, video, etc.) captured using the separate camera may be transferred and/or stored in the mobile communication device, and/or in other locations. The mobile application may access the memory and/or storage locations of the mobile communication device to select the images and/or video (and/or other visual data) captured using the separate camera with the reference object near the ears. The server may process the plurality of images received from the mobile communication device and/or uploaded via the application website to create a three dimensional model of the user's ear(s). Then, a model of the personalized earphone unit is created, based on the 3D model of the user's ear(s), the user's preferences, and/or other information. The modeled earphone may be representative of an earphone that may be inserted or placed comfortably in the user's ear. Thus an accurate size and shape of the ear may be measured and/or an equivalent three dimensional model may be produced by using the present system.

The website, mobile application, and/or other components of the system may allow a plurality of users (e.g., designers and/or other users) to market, purchase, and/or otherwise share a plurality of designs and/or matching products/accessories, including a plurality of add on elements and/or custom printed earphones through a marketing page associated with the mobile application and/or the website. Further, the system may be configured such that the users may be allowed to share the designs through the mobile application and/or website and/or through various social networking sites. The system may be configured such that the plurality of users may rate and/or review the plurality of products/designs shared through the mobile application, website, and/or integrated social networking arenas, for example.

These and other features, and characteristics of the present technology, as well as the methods of operation and functions of the related elements of structure and the combination of parts and economies of manufacture, will become more apparent upon consideration of the following description and the appended claims with reference to the accompanying drawings, all of which form a part of this specification, wherein like reference numerals designate corresponding parts in the various figures. It is to be expressly understood, however, that the drawings are for the purpose of illustration and description only and are not intended as a definition of the limits of the invention. As used in the specification and in the claims, the singular form of "a", "an", and "the" include plural referents unless the context clearly dictates otherwise.

### BRIEF DESCRIPTION OF THE DRAWINGS

FIG. 1 illustrates a server and a plurality of electronic communication devices connected to the server over a communication network forming a computer implemented system for producing a personalized earphone unit.
FIG. 2 illustrates a block diagram of an electronic communication device for processing the instructions of a mobile application associated with the computer implemented system for producing the personalized earphone unit.
FIG. 3 illustrates a block diagram of a server running a three dimensional personalized earphone unit model generating application associated with the computer implemented system for producing the personalized earphone unit.
FIG. 4 illustrates a computer implemented system for producing the personalized earphone unit.
FIG. 5A illustrates a flow chart showing a method of producing the personalized earphone.
FIG. 5B illustrates a flow chart showing a method of producing the personalized earphone unit.
FIG. 6A to FIG. 6E show a plurality of views of a graphical user interface of the mobile application configured to facilitate capturing the visual data (e.g., a plurality of images and/or video) of an ear of a user.
FIG. 7A to FIG. 7D show a series of simulation images illustrating force on an earphone unit (e.g., measured and/or studied by adding a plurality of load steps using the sample simulation programs running on a server).
FIG. 8A and FIG. 8B show mechanical simulation diagrams illustrating areas of stress on the earphone unit where different types of materials may be used for the construction of the earphone unit.
FIG. 9A to FIG. 9C show a plurality of diagrams of trajectory of the head of the user during three different activities such as dancing, boxing, and running, respectively, from a motion capture analysis.
FIG. 10A and FIG. 10B show the maximum stress on the ears of the user by the earphone unit determined based on dynamic analysis during a dancing activity by the user.
FIG. 10C and FIG. 10D show the maximum stress on the ears of the user by the earphone unit (e.g., obtained by conducting dynamic analysis during a boxing activity).
FIG. 11A and FIG. 11B illustrates views of a graphical user interface of the mobile application showing an immersion level for the user.
FIG. 11C and FIG. 11D show views of the graphical user interface illustrating a real world notification adjustment user interface screen of the mobile application.
FIG. 12 and FIG. 13 show two different perspective views of a personalized earphone unit formed by assembling three custom parts printed using a three-dimensional printer unit.
FIG. 14 is a perspective view showing a pair of assembled personalized earphone units constructed from the three custom parts printed using the three-dimensional printer unit.
FIG. 15 and FIG. 16 are exploded views of a personalized earphone unit showing a plurality of 3D printed parts of a wired/tethered personalized earphone unit.
FIG. 17 shows an assembled view of a personalized earphone unit made from a 3D printed interchangeable unique bezel, a cap, and a base.
FIG. 18 and FIG. 19 illustrate exploded views of a personalized earphone unit showing the interchangeable unique bezel, the cap, the base, and a plurality of audio electronic components of a wired and/or wireless personalized earphone unit.
FIG. 20 shows a plurality of audio electronic components with a battery placed inside an electronic components package of the personalized earphone unit.
FIG. 21 and FIG. 22 are exploded views of a personalized earphone unit showing a plurality of 3D printed parts, an electronic components package, a sensor, and a microcontroller.

### DETAILED DESCRIPTION

In the following detailed description, a reference is made to the accompanying drawings that form a part hereof, and in which the specific embodiments that may be practiced is shown by way of illustration. These embodiments are described in sufficient detail to enable those skilled in the art to practice the embodiments and it is to be understood that the logical, mechanical and other changes may be made without departing from the scope of the embodiments. The following detailed description is therefore not to be taken in a limiting sense.

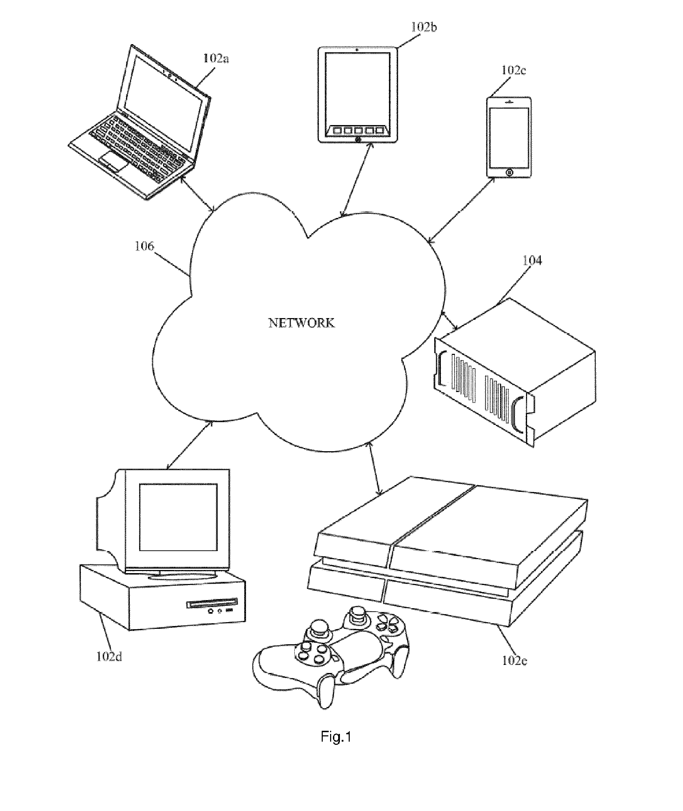

Referring now to FIG. 1, a computer implemented system 100 for producing a personalized earphone unit 114 is described. The computer implemented system 100 may include at least one server 104, a plurality of electronic communication devices 102a-102n connected to the server 104 over a communication network 106 for transferring a plurality of information for the purpose of producing the personalized earphone unit 114, and/or other devices. The computer implemented system 100 for producing the personalized earphone unit 114 comprises an online application and/or a website accessible via any networkable device such as a PC, laptop, desktop, tablet, smart wearable devices, etc., and/or a mobile application capable of being installed in the plurality of electronic communication devices 102 for obtaining at least one shape and size of a pair of ears of a user. The 3D cameras built into any of the listed networkable devices, as supported in the Intel® RealSense™ technology, can be used to capture the shape and size of a pair of ears of a user.The computer implemented system 100 further comprises the at least one server 104 for storing and processing the plurality of information including the shape and size of a pair of ears of the user, a plurality of preferences received from the user, and/or for storing a plurality of information including a plurality of user credentials for logging into the a website and/or the mobile application designed for obtaining the front and/or back structure of the ears of the user. The front structure of the at least one ear of the user refers to starting portion of the ear canal also known as the outer ear. The front structure of the ear is obtained for primarily designing a three-dimensional in-ear earphone model.

The users may download the mobile application to their electronic communication devices 102a- 102n. The electronic communication devices 102 may include, but are not limited to, a laptop 102a, a desktop 102d, a tablet 102b, a gaming console 102e, scanners, and/or other electronic devices that may be connected to a computer, and/or standalone network capable devices. The mobile application may be launched from the electronic communication device 102 such as a smartphone and/or a tablet computer and/or may be used to capture and/or send the front and/or back structure of the ears of the user. The plurality of information provided by the user using the mobile application and/or the website may be uploaded to the at least one server 104 by sending the information over the communication network 106. In some embodiments, the computer implemented system 100 may enable the plurality of users to share a plurality of designs for the earphone by posting in the website and/or from the mobile application using the plurality of electronic communication devices 102 connected over the communication network 106. The server 104 may share the plurality of information including designs for the personalized earphone units and information about a three dimensional model of the personalized earphone unit 114. The model may be generated using at least one application installed in the server 104, which generates the three dimensional model of the objects based on images and/or video received from the mobile application installed in the electronic communication devices 102, and/or other information.

The images and/or video of the user's ear(s) may be captured by any device capable of capturing visual data, such as laser scanners, infrared cameras, stereoscopic cameras, ultrasound, computer vision technology, digital ear scanning technology, or other cameras, any device which is either network capable or capable of being connected to the user's mobile communication device or computer unit to upload the images. Additionally, physical molds of the ear may be sent.

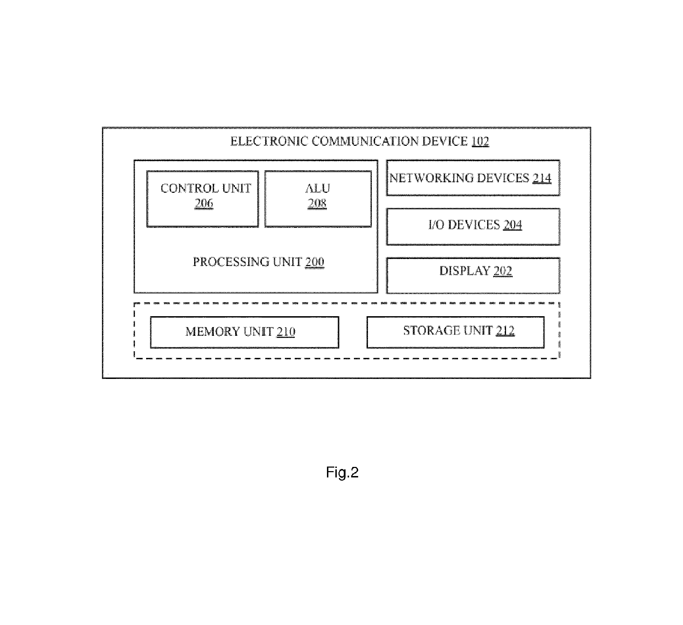

Referring now to FIG. 2, the electronic communication device 102, which includes, but is not limited to, a smartphone, a tablet, an ultrabook, a laptop, a smart wearable device including Google Glass, a smartwatch, etc., may include at least one processing unit 200 configured to process a number of applications including the mobile application and/or website associated with the computer implemented system 100 for producing the personalized earphone unit 114. The mobile application installed in the electronic communication device 102 may allow the plurality of users to login to submit a plurality of videos and/or images (and/or other visual data) detailing at least one front and/or back structure of the pair of ears of the user through a user interface. The processing unit 200 may process the plurality of inputs related to the captured video and/or image and/or design preferences for the personalized earphone unit 114 set by the user. The processing unit 200 may transfer the inputs from the plurality of users to the server 104 for further processing and three dimensional modeling of the personalized earphone unit 114.

In some embodiments, the at least one processing unit 200 may be configured to process a plurality of instructions from at least one website and/or mobile application designed to allow the plurality of users to provide a plurality of images and video (e.g., video data) detailing front and back structure of the pair of ears through the user interface of the website. The mobile application or the website may allow the users to submit a plurality of information in form of text, images, video, and/or formats through the user interface for submitting to the server 104. The server 104 may include at least one software for developing at least one three dimensional model of the user's ear(s) and then the earphone unit from the plurality of images and/or video (and/or other visual data) received by the server 104 and based on the user's preferences. The three dimensional model of the earphone created by the application in the server 104 may be sent to a three dimensional (3D) printer unit over the communication network 106. The model may be sent with any information such as the design preferences by the user and the 3D printer unit may print the personalized earphone unit 114 that can form a comfortable fit with the pair of ears of the user.

In some implementations, the mobile application may be configured to launch at least one camera module. The mobile application may access a storage area of the electronic communication device 102 for capturing and/or retrieving the at least one video and/or a plurality of images related to the interior and/or exterior structure of the ear(s) of the user. The electronic communication device 102 may include a variety of hardware and/or associated software components. The variety of hardware components may include the at least one processing unit 200 designed to control various other circuits such as information displayed on a display 202.

The display 202 may display a graphical user interface of the mobile application and/or the website. Moreover the display 202 may include at least one touch screen technology allowing the plurality of users to control the graphical user interface of the mobile application and/or the website using at least one gesture and/or touch. The processing unit 200 may control the information based on inputs received from various input/output (I/O) devices 204 of the electronic communication device 102 (e.g., hard keys, a touch screen, voice commands from a microphone or a microphone connected to headset jack, and/or from some other user input device).

The electronic communication device 102 may comprise the at least one processing unit 200, and/or other components. Processing unit 200 may include a control unit 206, an Arithmetic Logic Unit (ALU) 208. Device 102 may include a memory unit 210, a storage unit 212, a plurality of networking devices 214, a plurality input/output (I/O) devices 204, and/or other devices. The electronic communication device 102 may be composed of multiple homogeneous and/or heterogeneous cores, multiple CPUs of different kinds, special media, and/or other accelerators. The processing unit 200 may include a memory that stores data, and/or other components.

The processing unit 200 may include only one of a type of component (e.g., one microprocessor), and/or may contain multiple components of that type (e.g., multiple microprocessors). The processing unit 200 may be composed of a plurality of separate circuits and/or discrete circuit elements. In some embodiments, the processing unit 200 may comprise solid state electronic components such as a microprocessor (e.g., a microcontroller). The processing unit 200 may be mounted on a single board in a single location and/or may be spread throughout multiple locations, which cooperate to act as processing unit 200. In some embodiments, the processing unit 200 may be located in a single location (e.g. in proximity to, and/or on a common circuit carrying element such as a circuit board). In some embodiments, the components of the processing unit 200 may be closely connected.

The mobile application may include an algorithm configured to facilitate verifying and manipulating the plurality of information received from the plurality of users. The mobile application may be stored inside the storage unit 212 (and/or in other locations) and made available to the memory unit 210 during execution by the mobile application. The processing unit 200 may be responsible for processing instructions based on the algorithm. The processing unit 200 may receive commands from the control unit 206 in order to perform its processing. The plurality of processing units 200 may be located on a single chip and/or on multiple chips. Logical and/or arithmetic operations involved in the execution of the instructions may be computed with the help of the ALU 208.

The storage unit 212 may be configured to store the mobile application for processing the information (e.g., visual data) received from the camera, and/or other devices. The information may include at least one image detailing a front and back structure of the pair of ears of a user. The memory unit 210 may store the data during run-time (e.g., while performing operations with the data received from the mobile application), which may include automatic verification of the captured images and video for ensuring the quality of the images and video captured before sending it to the server 104 for further processing. In some embodiments, the plurality of images and the video detailing the size and shape of the pair of ears of the user may be captured using a separate electronic device and transferred, stored, and/or made accessible to the plurality of other electronic communication devices 102 and the mobile application and/or the website. The mobile application and/or the website may access the storage unit 212 to retrieve information including the plurality of stored images and/or video of the pair of ears of a user.

In some embodiments, such as when the user uploads the images and/or video from a standalone device, such as a scanner, the verification process may be performed by the server and feedback may be sent to the user via the mobile app, website, email, and/or text message, etc. In some embodiments, the mobile application and/or the website may send and/or receive information including designs for earphone units, add-ons for the earphone units, a plurality of stored images and/or video of the user's ear(s), etc. The system may include a program for three dimensional modeling of the ears based on a photogrammetry analysis. The program may run on the server 104 and processes the plurality of received images and/or video of the structure of the ear(s), the plurality of design preferences from the users, and/or other information. The program may thereby allow the plurality of users to design their own personalized earphone units 114 that would form a comfortable fit with the ears of the user without falling off, and would be specifically designed to stay in place while the user engages in his/her desired activities while wearing the earphone(s). In some embodiments of the invention, the mobile application may suggest at least one design for the plurality of earphones and based on that suggestion, the users may create the custom fit personalized earphone units 114.

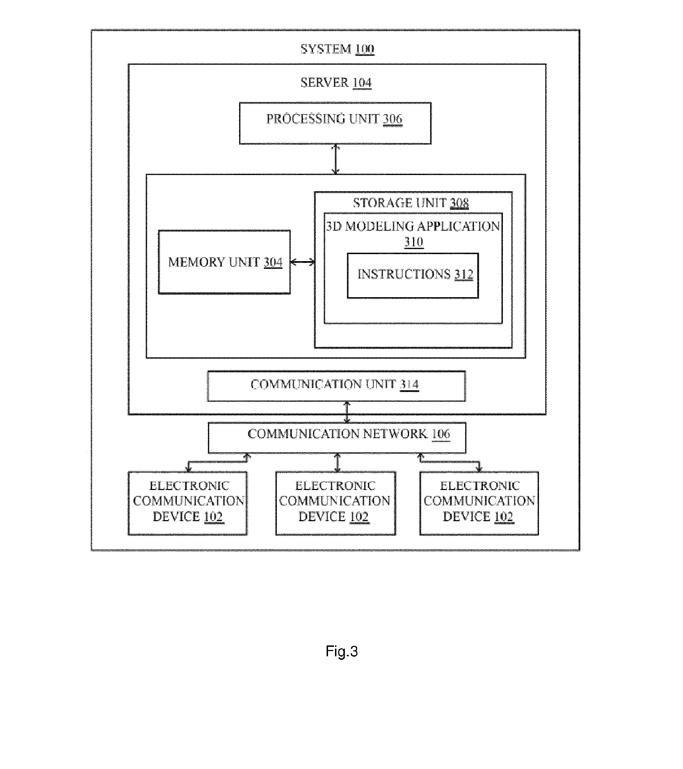

FIG. 3 illustrates a block diagram of the at least one server 104 running at least one three dimensional personalized earphone unit model generating application associated with the computer implemented system 100 for producing the personalized earphone unit 114. The plurality of electronic communication devices 102 for capturing the images and video of the pair of ears may be used to access the server 104 at which an instantiation of a computer-based application, which provides the network-based and other features discussed below, may be installed and accessible. Such access may be by way of a computer network or communication networks 106, such as the network of networks commonly known as the Internet. In some cases, the communication network 106 may include a local and/or wide area network or mobile communication network. In other instances, the communication network 106 may be a local area network (LAN) of an enterprise and/or a virtual LAN, which is instantiated over the Internet or other networks of networks. The server 104 may be communicatively coupled to a database, which may store records concerning user credentials, user ratings and credits, feedback details, electronic user profiles, etc.

The server 104 may include similar hardware as in a computer system which includes a processing unit 306, a network communication unit 314, at least one memory unit 304, a storage unit 308, a plurality of I/O devices 320 for connecting to a plurality of peripheral devices including a display unit, and/or other components. The server 104 may be run by operating system software and/or firmware. Server 104 may include a customized 3D modeling application 310 having a plurality of instructions 312 for managing the operations of the user management and earphone 3D modeling service.

As described herein, this service may be made available to the plurality of users through the (e.g., graphical) user interface of at least one website and/or the mobile application configured to run on the plurality of electronic communication devices 102. The server 104 may include a database utility for storing a plurality of information of the plurality of users. The server 104 may include processing methods based on the plurality of instructions of the customized 3D modeling application 310 embodied in the memory unit 304 and executed by the processing unit 306. The plurality of instructions 312 of the customized 3D modeling application 310 executed by the processing unit 306 may provide information through the user interface of the website and/or the mobile application ('App') capable of being launched on the variety of electronic communication devices 102. The customized 3D modeling application 310 running on the server 104 may include the plurality of instructions 312 for the modeling of the user's ear(s) through photogrammetry and for the design and modeling of a variety of earphone units and for the processing of the inputs from the plurality of users. The inputs from the plurality of user may include material, color and style selection, ergonomic options, description of user's activities during which the earphones may be worn, and add-ons with the earphone unit. The customized 3D modeling application 310 may save the plurality of design inputs and add-on selections from the plurality of users. The customized 3D modeling application 310 running on the server 104 may enable the plurality of electronic communication devices 102 to display the plurality of information on the user interface of the website and/or the mobile application including a 3D design of a proposed earphone unit.

The electronic communication device 102 is selected from a group of devices having network connectivity for connecting to the internet for receiving a plurality of information from the server 104. The electronic communication device 102 may include personal computers such as desktops, a Smartphone, tablet, ultrabook or laptop, Google glass, Smart wearable devices including a smart watch, and/or other devices. The electronic communication device 102 may have at least one processing unit configured to process a number of applications for sending and/or receiving the plurality of information from/to the 3D modeling application 310 running on the server 104, for example. The server 104 may process the data received from the mobile application and/or from the website launched from the electronic communication devices 102 and create a 3D model of the user's ear(s) and then, based on the user's 3D ear model and/or the user's preferences, create a 3D model of the earphones. Then, the 3D model of the earphones may be sent to the 3D printer unit for printing the personalized earphone unit 114. The data inputted to the 3D modeling application 310 running on the server 104 may include at least one model for the earphone unit 114, a plurality of images or a video with a reference object with standard size and clearly showing the shape and size of the earphone unit, other inputs such as material for use, color, design, ergonomics options, soundscaping options, add-ons, and/or other information.

The server 104 may be in communication with the plurality of electronic communication devices 102 through wired and/or wireless means. The wired and/or wireless communication may facilitate generating the personalized earphone unit 114 based on the plurality of inputs from the users. The server 104 may include the 3D modeling application 310 for processing the plurality inputs from the users received through the mobile application or the website running on the electronic communication device 102. The server 104 may be capable of routing a plurality of information including the plurality designs of the earphone unit, add-ons, etc. to the mobile application and/or the website launched on the plurality of electronic communication devices 102 over the communication network 106.

In some embodiments, the user interface of the website and/or the mobile application may facilitate interaction with the mobile application executing on the electronic communication devices 102 (such as a Smartphone). In some embodiments, the mobile application ("App") for printing personalized earphone units 114 may have a plurality of different functions and/or menu options available to the user. In some embodiments, an individual function may have a corresponding screen display layout and/or interface. Individual menu option's respective screen display layout may occupy most and/or substantially the entire device display screen. The term "screen display layout" may refer to content that appears on the device display screen at a given time, and/or other information.

Additional aspects of the present user interface may include arrangements for viewing and/or selecting among the various different functions and/or menu options that may be available during execution of the given mobile application. In some embodiments, upon selection of a function, the selected function user interface related to the plurality of options may be available. Such options may include the inputting a plurality of designs for the earphone, capturing at least one image and/or video of the pair of ears, sharing the designs with other users and getting feedback and comments, etc. Information related to one option may then occupy most and/or substantially the entire device display screen at a given time, for example. In this way, available display screen "real estate" may be maximized for individual functions and/or features of the running mobile application. In some embodiments of the present invention, the computer implemented system 100 for producing personalized earphone units 114 may be accessible through the website controlled by the server 104. The plurality of users of the website may receive the plurality of services from the computer implemented system 100 such as, but not limited to, printing the personalized earphone unit 114 having a comfortable fit with the pair of ears, variety of designs of the earphone, earphone body material selection, ergonomics inputs and options, Soundscaping options, add-on selections, selections of matching accessories and apparel, sharing and getting feedback from other users, user credits for comment or feedback, information about the progress of producing the personalized earphone 114 with the selected design etc.

The algorithm of the 3D modeling application 310 comprising of instructions 312 and codes required for the 3D modeling of the user's ear(s) and earphone unit for the users based on the plurality of videos or images of the ears and preferences by individual ones of the users and are stored in either the memory unit 304 or the storage 308 or both. At the time of execution, the instructions 312 may be fetched from the corresponding memory 304 and/or storage unit 308, and executed by the processing unit 306. The various networking devices or external I/O devices 320 may be utilized for interconnecting with a variety of external devices through wireless/wired network. The electronic communication device 102 include the plurality input/output (I/O) devices 320 e.g. button, switch, touch screen, keyboard, keypad, voice command circuit, etc. for registering commands from the user through the mobile application. Some and/or all of the plurality input/output (I/O) devices 320 may include an alphanumeric keyboard. The keyboard may comprise, for example, a QWERTY key layout and an integrated number dial pad. A keyboard integrated into a hand-held device would typically be a thumb keyboard. The plurality input/output (I/O) devices 320 may also include various keys, buttons, and switches such as, for example, input keys, preset and programmable hot keys, left and right action buttons, a navigation button such as a multidirectional navigation button, phone/send and power/end buttons, preset and programmable shortcut buttons, a volume rocker switch, a ringer on/off switch having a vibrate mode, and so forth. Any of the plurality input/output (I/O) devices 320 may be concealable behind a body e.g. a sliding body, a flip-out body, etc. such that they are hidden when the body is in a first position and visible when the body is in the second position. Generally, the electronic communication devices 102 may run the mobile application or software application or may be capable of launching the website for obtaining or capturing and uploading the plurality of images and video detailing the structure of the pair of ears of the users captured with at least one standard sized reference object such as a coin. However, as described herein the electronic communication devices 102 may also run a system application specially configured to interface with the 3D modeling application running on the server 104.

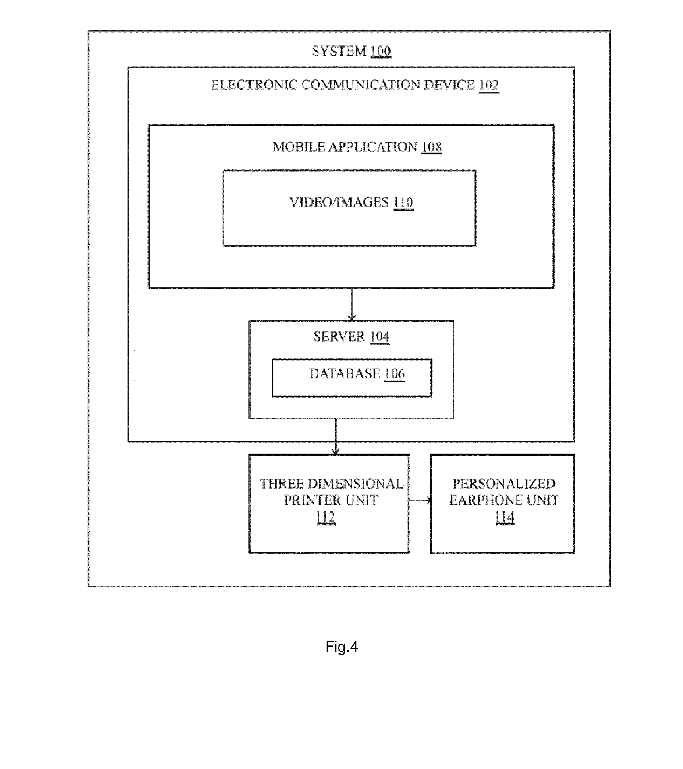

Referring now to FIG. 4, a computer implemented system 100 for producing the personalized earphone unit 114 is disclosed. The computer implemented system 100 comprises the mobile application 108 installed in an electronic communication device 102 for obtaining the plurality of images 110 or at least one video detailing at least one front structure and/or at least one back structure of the pair of ears of the user, the server 104 for storing and processing the plurality of images 110 and the video and for storing a plurality of information including a plurality of user credentials for logging into the website or the mobile application 108 designed for obtaining the front and/or back structures of the ears of individual users. The computer implemented system 100 further includes a three dimensional printer unit 112 for generating at least one personalized earphone unit 114 based on the plurality of images 110 of the pair of ears of the user. The user can download the mobile application 108 to their electronic communication device 102. The mobile application 108 can be launched from the electronic communication device 102 such as a smartphone or a tablet computer and can be used to shoot the plurality of images 110 of the ears of the user. The plurality of images 110 can be examined by using the mobile application 108 and thereafter the plurality of images 110 is uploaded to the at least one server 104. The server 104 processes the plurality of images 110 received from the electronic communication device 102, and the capture may be processed to create a three dimensional model of user's ear(s) and then a model of the personalized earphone unit 114 which can be inserted or placed comfortably in the user's ear may be created based on the user's preferences.

In some embodiments, the server 104 may be coupled to a database 116 and/or the communication network 106 as in FIG. 4. In this specification, the term "couple" refers to any direct or indirect communication between two or more elements, whether or not those elements are in physical contact with one another. The server 104 performs one or more functions to process the plurality of inputs from the users, and generate a three dimensional model of the user's ear(s) based on photogrammetry analysis, and then generate a model of the earphone unit that could be sent to the 3D printer unit 112 for producing the personalized earphone unit 114. The server 104 may include any hardware, software, firmware, or combination thereof operable to perform one or more functions computer implemented system 100 for producing the personalized earphone unit 114. The database 116 coupled to the server 104 may store records concerning user credentials, payment details, preferences of individual users, social network profiles, etc. The database 116 is coupled to server 104. The database stores and facilitates retrieval of information used by the server 104, the information may include a plurality of user information including user credentials. The database 116 may store information related to the plurality of videos and the plurality of images uploaded by individual users. This information may be used by server 104 to perform operations using the 3D modeling application 310, for generating the 3D model of the personalized earphone unit 114. The database 116 may include any hardware, software, firmware, or combination thereof operable to store and facilitate retrieval of information. Also, the database 116 may use any of a variety of data structures, arrangements, and compilations to store and facilitate retrieval of information.

The communication network 106 is coupled to the server 104 and the plurality of electronic communication devices 102. The communication network 106 facilitates communication between components of the computer implemented system 100 for producing the personalized earphone unit 114. For example, the communication network 106 may communicate Internet Protocol (IP) packets, frame relay frames, Asynchronous Transfer Mode (ATM) cells, or other suitable information between network addresses. The communication network 106 may include one or more local area networks (LANs), metropolitan area networks (MANs), wide area networks (WANs), all and/or a portion of a global network such as the Internet, or any other communication system or systems at one or more locations.

The present invention provides systems and methods for producing custom earphones. The custom earphones may be designed and produced such that an individual earphone fits well into the ears of the individual users, and suits the user's activity/ergonomic preferences, aesthetic preferences, as well as provides users with a plurality of options for add-on capabilities as well as options to design or purchase matching accessories or apparels to be integrated with the earphones. The personalized earphone unit 114 can be assembled with audio signal generating electronic components for converting electrical signals to audio signals. The mobile application 108 can be downloaded into the electronic communication device 102. The mobile application 108 is designed to run on a variety of electronic communication devices 102 running on a variety of operating systems including, but not limited to Android, Android SDK, iOS, Blackberry operating system, Windows phone operating system, Sailfish operating system, Firefox operating system, Tizen operating system, Ubuntu Touch operating system, macOS, Chrome, and webOS. The mobile application 108 is designed to be compatible with a variety of electronic communication devices 102 including, but not limited to smartphones, tablets, laptops, ultrabooks, convertibles, smart wearable devices including Google Glass, smart watches, desktop computers, standalone networkable devices, etc. The user can install the downloaded mobile application 108 in the electronic communication device 102 or access the application website. When launched a user interface of the mobile application 108 may be displayed on a screen of the electronic communication device 102. The user interface of the mobile application 108 allows the users to select a desired mode of training such as video, text, or image for operating the electronic communication device 102 to capture a detailed front and/or back structure of the ears. The user can select the desired training method from the user interface of the mobile application 108. First the user can go through a training session having at least one training video or a series of images or text instructions on how to use the mobile application 108 running on the electronic communication device 102 for capturing the front and/or back structure of the ear(s) of the user, and if relevant for the user's preferred earphone design, capturing the user's neck and or head for neck/headband, etc. After watching the short instructional video of how to video capture a proper set of images of the user's ears, and other anatomy of the head if relevant, the user may be prompted to use the camera of the mobile phone to capture a video or a plurality of images by orbiting around the user's ear, and other anatomy if relevant. The data obtained by using the camera may be processed by the mobile application 108 and/or by the server 104 and feedback may be presented to the user. Based on the feedback displayed on the user interface of the mobile application 108 the user can understand whether or not the capture was successful. If the capture is not successful the user may be prompted to do the capture once again for obtaining a detailed front and/or back structure of the ears of the user. If the capture is successful then the data may be uploaded to the at least one server 104 through a communication network 106. The user can choose the type of earpiece desired, material to be used, model and style, fitting preferences, ergonomic preferences, specify activities during which the user may be wearing the earphones, Soundscaping preferences, add-ons, etc. from the user interface of the mobile application 108. The communication network 106 is created by using any one of but not limited to the following communication means including Wi-Fi, mobile data communication, Bluetooth, infrared, near field communication, etc. The server 104 may process the data received from the mobile application 108 running in the electronic communication device 102 for modeling a three dimensional structure of the ears (and other anatomy of the user's head, such as neck/cranium if relevant to the choses earphone design) of the user and a three dimensional model of the earpiece that fits well into the user's specific ear.

In some embodiments of the present invention, a plurality of images 110 of the ears of the user is captured using the camera of the electronic communication device 102. The plurality of images 110 of the ears is captured in the presence of a reference object placed near the ears of the user. The reference object helps in analyzing the size of the ears of the user. During the process of scanning or picturing or video recording to capture the images of the ears, an easily found household item, such as a coin, is placed near the ear. When performing the scan, the reference object may be used as measurement reference when processing the scale of the model. In some embodiments of the present invention, the user may capture at least one picture of the ear using a separate camera, facing the mobile phone screen or tablet screen to the camera, or use a mirror to capture both the screen of the phone and the ear in the same frame. The screen of the mobile phone or tablet can be used as a scale reference to the scanned model, by means of a downloadable QR barcode to be displayed on the screen. The images or the video 110 captured using the separate camera can be transferred and stored in the electronic communication device 102 or transferred directly to the server 104. The mobile application 108 can access the memory or storage locations of the mobile communication device 102 to select the images or video captured using the separate camera with the reference object near the ears. Thus an accurate size and shape of the ear can be measured and an equivalent three dimensional model can be produced by using the computer implemented system 100 of the present invention.

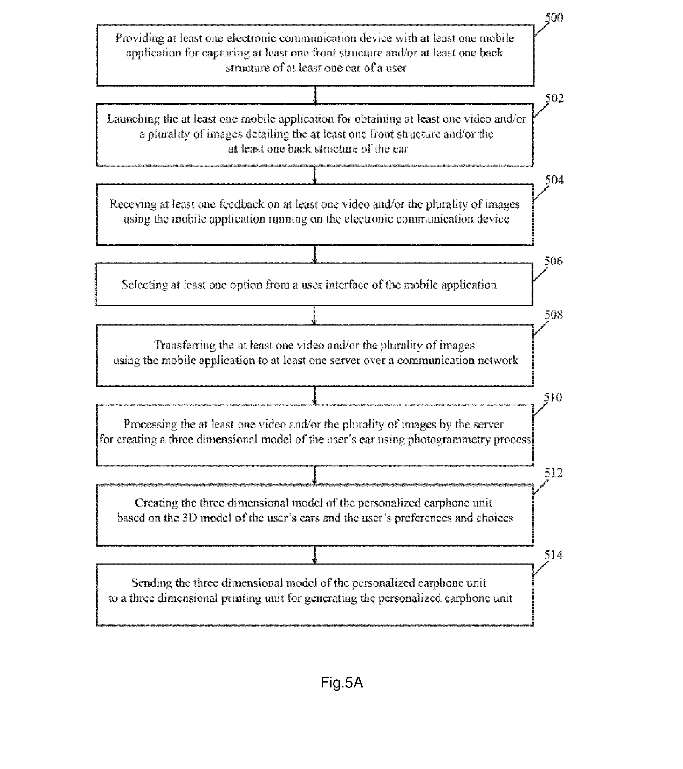

FIG. 5A illustrates a flow chart showing a method of producing the personalized earphone unit 114 by utilizing the mobile application 108 for communicating with the computer implemented system 100. The method starts by providing the electronic communication device 102 installed with the mobile application 108 for capturing at least one front structure and/or at least one back structure of at least one ear of a user, and possibly neck/back of ears/other anatomy of the user's head as relevant for the user's preferred earphone design, as shown in block 500. Then as in block 502, the mobile application 108 is launched from within the mobile communication device 102 to capture a video and/or a plurality of images detailing the at least one front structure and/or the at least one back structure of the ears of the user, and neck/head of user if relevant. The mobile application 108 may instruct the user through the capturing processing, such as by directing which part of the ear or user's head anatomy to capture and in which direction the user should move his/her head or which direction to move the camera/capturing device, as appropriate. Later, the captured video and/or the plurality of images may be processed in the mobile application 108 to check whether or not the captured video is sufficient to process the three dimensional earpiece model, as shown in block 504. This may be accomplished by checking the feedback result of the mobile application 108. The verification of the captured video or the plurality of images may be performed during the process of capturing the video or the images. During capturing the video or the plurality of images of the ear, if the speed of movement of the camera may be more than a predetermined speed or if the capture is out of focus then the mobile application 108 can automatically detect and notify the user about the faulty method and the user may be directed to again perform the capture. Then the user can select a desired product type, style and fitting preferences, ergonomic and Soundscaping preferences, add-ons, etc., of the earpiece from a user interface of the mobile application 108, as shown in block 506. The video or the images is captured with a standard sized item such as a coin or a scale placed near to the ears for accurately determining the shape and size of the pair of ears. Now, the captured video or the images with the user preferences for desired product type, style and fitting of the earphone is transferred to the server 104 which is in communication with the three dimensional printer unit 112 over the communication network 106, as shown in block 508. Then as is block 510, the video or the images detailing the front and/or back structure of the pair of ears of the user is processed to create a 3d model of the user's ear via a photogrammetry process involving search and matching feature point in the plurality of images, creating a coarse cloud point, creating dense cloud point, running a cloud point cleanup process in order to create a smooth mesh from the cloud point. Then as in block 512, a three dimensional model of the earpiece is created based on the 3D model of the user's ears and also by processing the plurality of user preferences and choices in the server 104 before sending it to the three dimensional printer unit 112. Based on the 3D model of the user's ear(s) and on the user desired product and product preferences, including choice of material(s) to print the earphone(s) from the user interface of the mobile application 108, the 3d model of the earpiece is processed. Then as in block 514, the three dimensional printer unit 112 is operated to print the personalized earphone unit 114. Then different audio electronic components are inserted to the personalized earphone unit 114 casing printed using the above said method for generating the personalized earphone unit 114. In some embodiments the audio electronic components were inserted to the personalized earphone unit 114 during the printing process using the 3d printer unit 112. Post-Processing Procedure: There are various possible post-processing steps, depending on user's preferences, including (1) tumble smoothing to smooth the 3D print, (2) vapor finishing, (3) PAD printing or silk printing to print graphics on the earphones, (4) Vapor Deposition to coat the printed earphone with metal coating, (5) "lost wax investment casting," (6) 3D printing of a mold of the intended earphones in order to cast them in various materials such as resin, polyurethane, metals, rubbers, etc. i.e., materials that are not yet efficiently printed using 3D printers, and/or (7) coating, painting, or dipping the printed earphones. These various post-processing procedures may be utilized to achieve cosmetic and/or utilitarian (such as comfort, durability, heat resistance) objectives of the user.

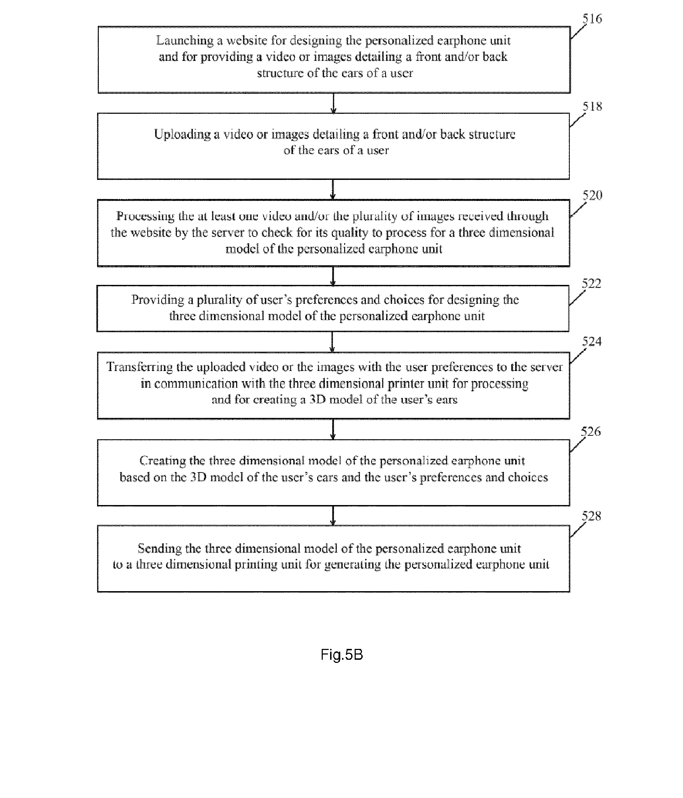

FIG. 5B illustrates a flow chart showing a method of producing the personalized earphone unit 114 by utilizing the website for communicating with the computer implemented system 100. The method starts by launching the website associated with the computer implemented system 100 for designing the personalized earphone unit 114 by providing at least one video or a plurality of images detailing at least one front structure and/or at least one back structure of at least one ear of a user, and possibly neck/back of ears/other anatomy of the user's head as relevant for the user's preferred earphone design, as shown in block 516. Later, the uploaded video or the plurality of images is processed by the server to check whether or not the captured video is sufficient to process the three dimensional earpiece model, as shown in block 518. The verification of the uploaded video or the plurality of images is performed by at least one server associated with the computer implemented system 100 for designing the personalized earphone unit 114. Then the user can select a desired product type, style and fitting preferences, ergonomic and Soundscaping preferences, add-ons, etc., of the earpiece from a user interface of the website, as shown in block 520. The video or the images should be captured with a standard sized item such as a coin or a scale placed near to the ears for accurately determining the shape and size of the pair of ears. Now, the uploaded video or the images with the user preferences for a desired product type, style and fitting of the earphone is transferred to the server 104 which is in communication with the three dimensional printer unit 112 over the communication network 106, as shown in block 522. Then as is block 524, the video or the images detailing the front and/or back structure of the pair of ears of the user is processed to create a 3d model of the user's ear via a photogrammetry process involving search and matching feature point in the plurality of images, creating a coarse cloud point, creating dense cloud point, running a cloud point cleanup process in order to create a smooth mesh from the cloud point. Then as in block 526, a three dimensional model of the earpiece is created based on the 3D model of the user's ears and also by processing the plurality of user preferences and choices entered through the website before sending it to the three dimensional printer unit 112. Based on the 3D model of the user's ear(s) and on the user desired product and product preferences, including choice of material(s) to print the earphone(s) from the user interface of the website, the 3d model of the earpiece is processed. Then as in block 528, the three dimensional model of the personalized earphone unit is send to the three dimensional printer unit 112 for printing the personalized earphone unit 114. Then different audio electronic components are inserted to the personalized earphone unit 114 casing printed using the above said method for generating the personalized earphone unit 114. In some embodiments the audio electronic components were inserted to the personalized earphone unit 114 during the printing process using the 3d printer unit 112. Post-Processing Procedure: There are various possible post-processing steps, depending on user's preferences, including (1) tumble smoothing to smooth the 3D print, (2) vapor finishing, (3) PAD printing or silk printing to print graphics on the earphones, (4) Vapor Deposition to coat the printed earphone with metal coating, (5) "lost wax investment casting," (6) 3D printing of a mold of the intended earphones in order to cast them in various materials such as resin, polyurethane, metals, rubbers, etc. i.e., materials that are not yet efficiently printed using 3D printers, and/or (7) coating, painting, or dipping the printed earphones. These various post-processing procedures may be utilized to achieve cosmetic and/or utilitarian (such as comfort, durability, heat resistance) objectives of the user.

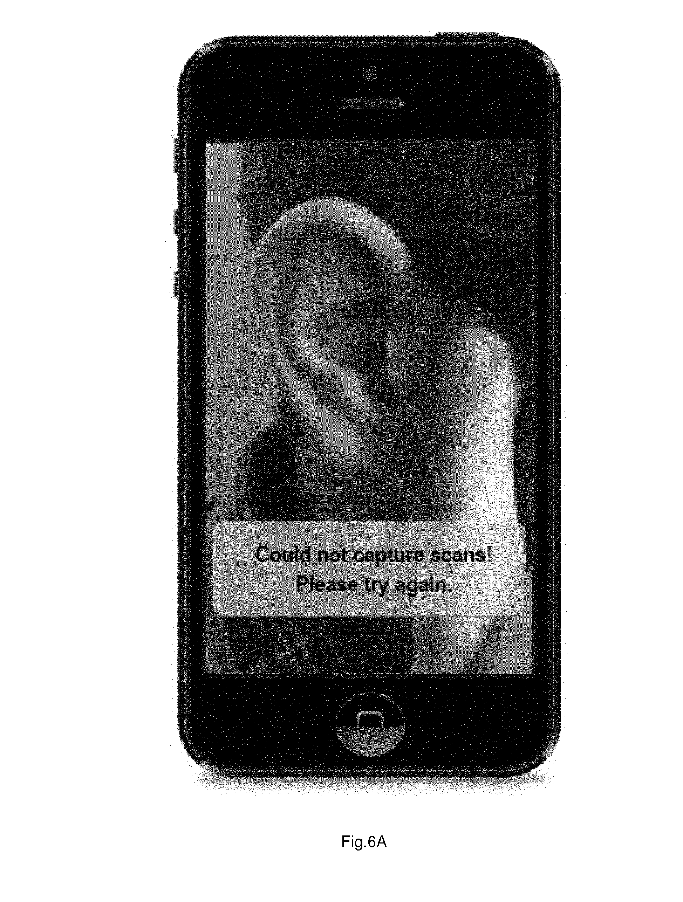

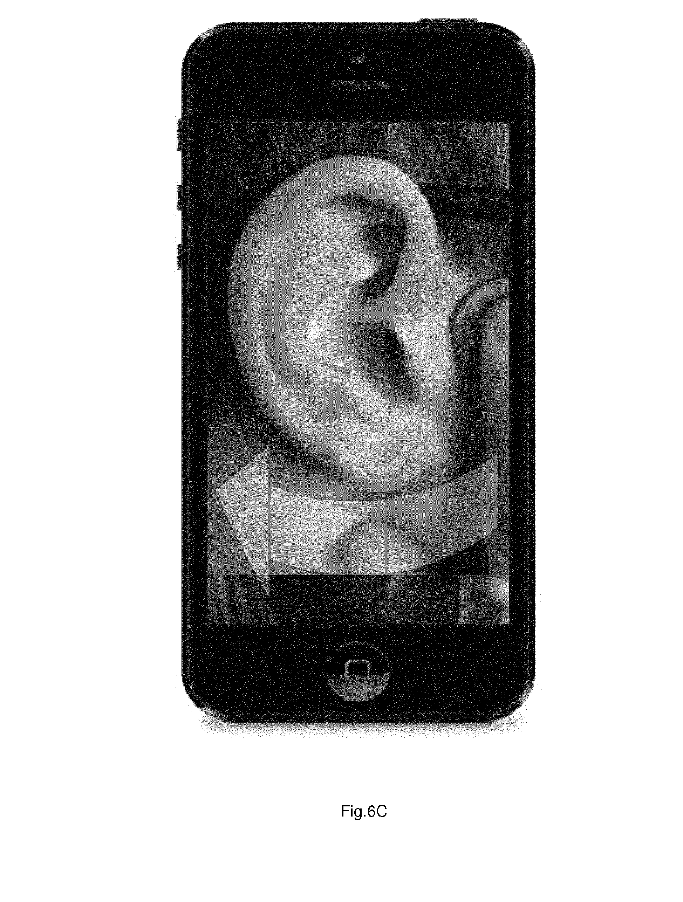

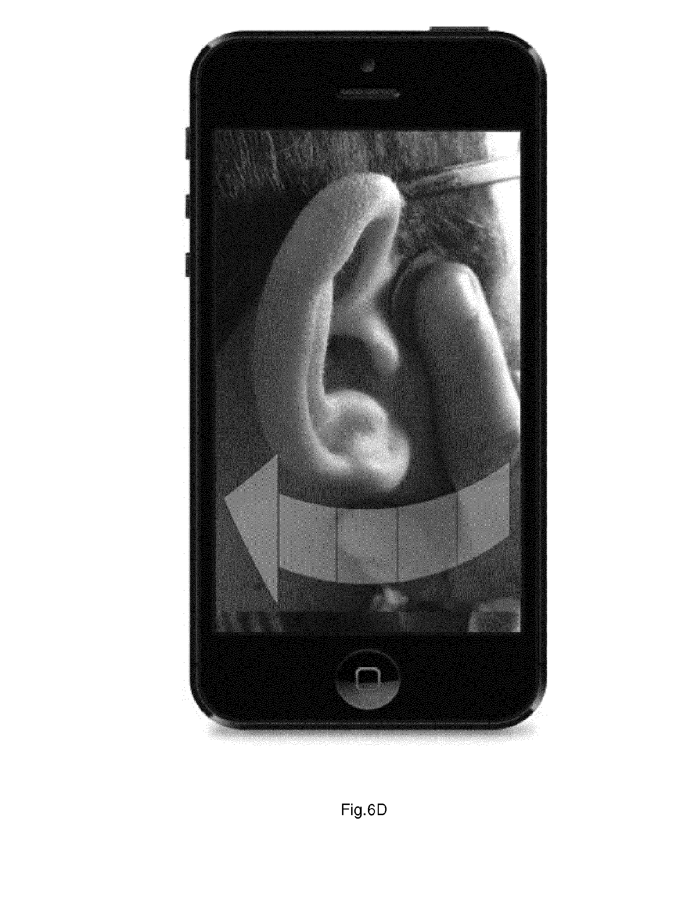

FIG. 6A-6E shows a plurality of user interface of the mobile application 108 for capturing the plurality of images and/or the video 110 of the at least one ear of a user. For sign in/signup to the mobile application 108 or application website, the users may be directed to a login section of the webpage or the user interface of the mobile application 108 which may further include links to a plurality of information description sections for describing the information including, but not limited to, a plurality of uses and advantages of the computer assisted system 100 for producing the personalized earphone unit 112. A registered user can enter user credentials such as a username and a password in the login section of the website or the user interface of the mobile application 108 to login to the mobile application 108 or application website. The username can be an email id of the user or a username selected by the user. For users who have not registered into the website or the user interface of the mobile application 108, users can register by providing a plurality of information in the signup page of the website or the user interface of the mobile application 108. The users may be provided with at least one unique user credentials for logging into the website run by the server 104 and the mobile application 108 running on the electronic communication device 102 and associated with the 3d modeling application running on the server 104. The website and the mobile application 108 is configured to allow login using the plurality of login credentials of a plurality of services including, but not limited to Gmail, Facebook, Amazon, LinkedIn, Google+, Yahoo mail, etc., thereby avoiding the necessity for registering/logging into the website and the mobile application 108 using its own credentials and can speed up the process of registering/logging into the website and the mobile application 108. For registering the users may be directed to provide a plurality of information including full name, contact information such as ad-dress, phone number, etc. if available. Alternatively the user can choose the username and password for using as the user credentials. Email address and phone number are requested, but are not necessary to complete the registration. In order to complete the registration process the users may be directed to provide at least one form of confirmation such as verification of the email address, verification of phone number etc. In addition the user may need to accept terms of service associated with the computer implemented system 100 for producing the personalized earphone unit 114. After verification of any of these items the users can login to the website or the mobile application 108. After logging into the website or the mobile application 108 the user can link their profile to social network accounts such as Instagram, Twitter, Tumblr, Google+, Pinterest, Facebook, etc.

After logging in to the website or the mobile application 108, the users may be redirected to a profile page of the user. The profile page may include a plurality of contact information of the user including phone numbers, Email ID, social network ID, etc. for enabling other users to contact, or communicate with the other users. The profile page may also include links to a plurality of information about a plurality of designs of earphone units by the user, a plurality of feedbacks given to other designs by the user, rating of the user and credits received by the user. The profile associated with an individual user is customizable at any time for changing/incorporating a plurality of information and for organizing the contents of the created profiles.

After logging into the mobile application and/or the website 108, the plurality of users may be provided with a user interface of a startup page of the computer implemented system 100 for producing the personalized earphone unit 114, where the users can find a plurality of information about the services offered by the system. The user interface of the startup page may include a plurality of options and a plurality of links to at least one training for using the website or the mobile application 108 for capturing at least one video and/or a plurality of images detailing a structure of the ears, and other relevant anatomy of the user's head if applicable, of the user using the mobile application 108 installed in the electronic communication device 102. In some embodiments, after logging in, the app may play a video/ animation tutorial showing the user how to capture a video orbiting around his/her ears. In some embodiments, the tutorial shows how to scan for capturing the back of the head to adjust the length of the neck wire or to create a solid back to connect between the left and right earphone, or for creating an over-the-head connection for the ear pieces. The mobile application 108 and the website allows the users to select and upload at least one image or video describing the shape and size of the ears and store the images/video in a memory location of the electronic communication device 102 or access such images/video from other storage devices. In addition, the mobile application 108 and the website can launch at least one camera of the electronic communication device 102 for capturing a video or images of the front and back structure of the ears of the user. The captured video and/or the plurality of images detailing the structure of the ears of the user is verified by using the mobile application 108 installed in the electronic communication device 102, or the verification process may take place on the server 104, shown in FIG. 3, in the case of images/video uploaded from other visual data capturing devices. The mobile application 108 and/or server 104, as shown in FIG. 3, may automatically verify the quality of the video and/or the plurality of images during the process of capturing and the user can see an onscreen feedback of the area he/she scans, and the area(s) still needed to be scanned, or rescan ned/recaptu red.

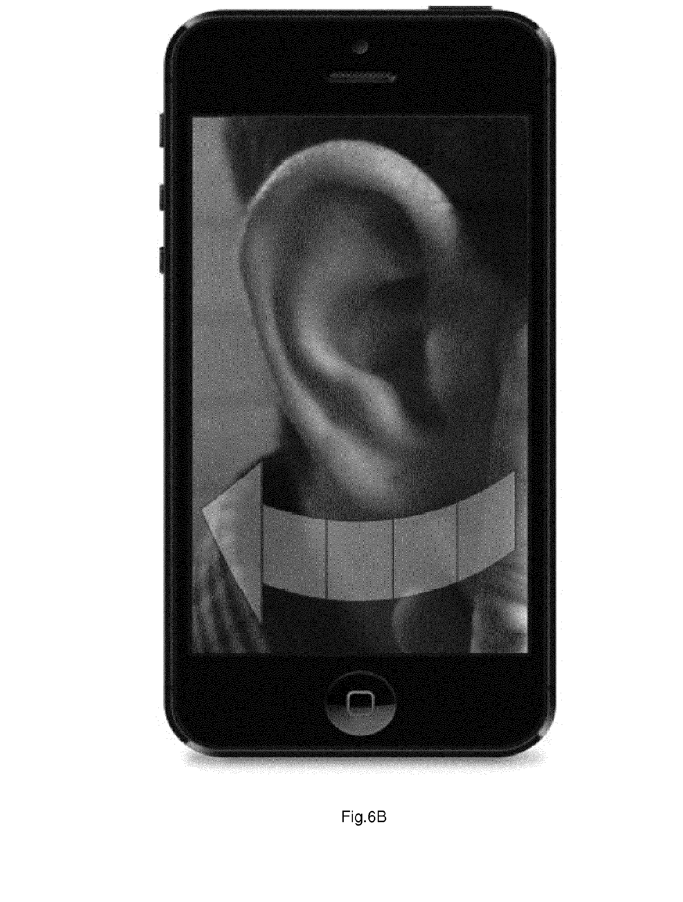

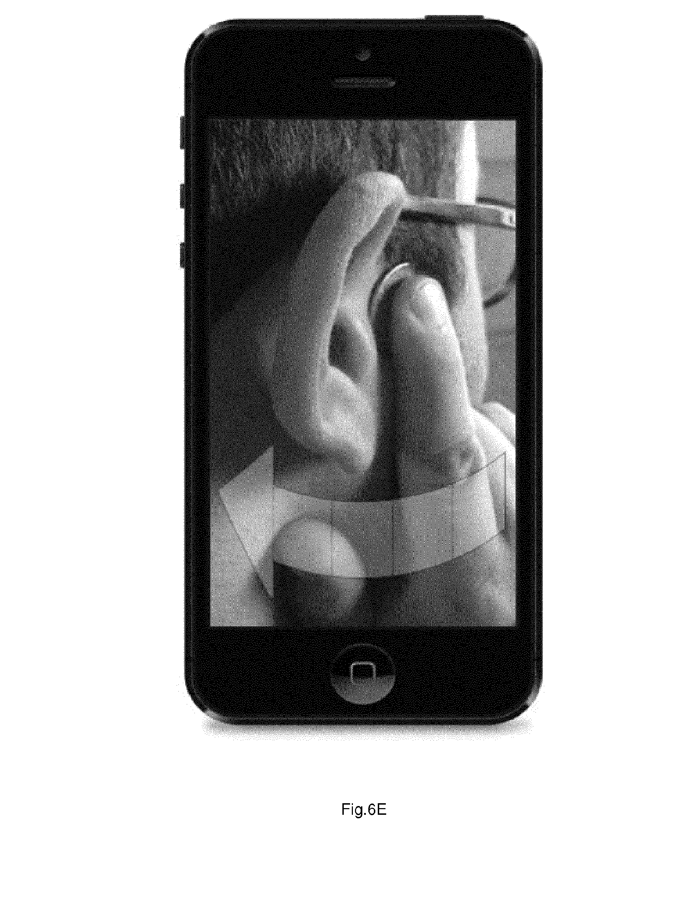

The plurality of screen shots of the user interface of the mobile application 108 for capturing the plurality of images and/or the video 110 is shown in FIG. 6A-6E. FIG. 6A shows a screen shot of the user interface of the mobile application 108 starting to scan an object using the electronic communication device 102. The user can first place a reference object, which is having a standard size, such as, but not limited to, a coin near the ear and can start the capturing process. The user can either keep his/her head stationary, with the reference object placed near the ear, and then the camera of the electronic communication device 102 is moved to capture the structure of the ears or can move his/her head keeping the camera of the electronic communication device 102 stationary. A 3d area map is shown on top of the video capture, with animation arrows moving to show the direction the user should move the camera around, or which direction to move his/her head. The captured video can be processed by the 3d modeling application running in the server 104 and can be utilized to construct the body part of the personalized earphone unit 114. FIG. 6B to FIG. 6D shows the screen shots during the movement of the camera. The reference object such as the coin is placed near the ear while the camera is moved around the head to capture the shape and size of the ear. The user can hold the coin near his/her ear and the images or video of the ear with the adjacently placed coin is captured using the camera launched from the mobile application 108 or the images or video of the ear with the adjacently placed coin can be captured using any video or image-capturing device. These videos can then be uploaded to the server 104 through the mobile application 108 or using the website. As areas are scanned, the animation arrows may change the color such as to green as shown. If the movement of the camera is too fast or if the object gets out of focus, or the user moves the camera in the wrong direction an error message may appear on the user interface as shown in FIG. 6A. In this case the user can repeat the process of capturing the video or the images. If the video or image capture is successful then the animation arrows may turn green as shown in FIG. 6E. In some instances, if the video or the images is captured successfully, the information is processed in the mobile application 108 to show a low-resolution model of the scan and the video and/or plurality of images is/are uploaded to the server 104 for further processing over the communication network 106.

In some embodiments, the processing of the plurality of images or the video of the ears sent from the mobile application 108 or the website is done on a cloud computing engine, to allow adjustment of computing power according to demand. Also the user can choose to upload a video that was taken with a different camera, or upload a 3d scan that was done on his/her ear using any other technology such as those mentioned previously. Also the user may be able to send a scan of an ear mold, or he/she can even opt to send an ear mold to the company or the manufacturer of the personalized earphone unit 114 to get scanned. The camera parameters may be sent along with the video footage. If it is a built-in phone camera, the phone model may be sent through the mobile app 108 to identify the lens specification to allow a better calibration of the reconstruction of the 3d earphone model using the 3d modeling application 310 and to compensate for lens distortion. If the video is uploaded from an external camera, the user may be asked to specify the camera model and lens that were used. Then the specification is compared with data available in the server database. In case the data for the camera model and lenses are not in the server database, the user may be asked to take a picture of a grid or other printed graphic that can be printed through the platform, in order to calculate the distortion. While the video is being uploaded to the server 104, a textured low polygon mesh is displayed to the user. The low polygon mesh may be presented on top of the textured model. Movement of the phone, or moving or touching the screen may move the model and may allow a limited 3d view of the object. Also, in some in-stances, a plurality of models and designs of the earphones unit may be displayed superimposed on the 3D model of the user's ears to simulate what the earphones may look like when the user wears them on his/her ears.

The plurality of images or video detailing the structure of the ears is then processed by Photogrammetry algorithm of the 3d modeling application. The photogrammetry algorithm of the three dimensional modeling application includes four main sequential procedures for creating the three-dimensional model of the earphone unit. The first step in the photogrammetry algorithm includes a feature point and match process. In this process, the images of the ear of the user sent through the mobile application or the website is analyzed or searched for any points in the picture that depict strong visual elements such as corners, and sharp changes in shape and color, which are called "feature points". Thus the shape of the ear can be modeled by finding the feature points in the image. After the feature points are identified from the first image, then the photogrammetry program search for the same points in the other images. Then the photogrammetry algorithm follows a bundle adjustment step. In this step, by using the matched feature point and information on the camera, such as lenses, sensor size etc., the photogrammetry program calculates a coarse point cloud. The bundle adjustment step of the photogrammetry algorithm finally positions the 2D images of the ears of the user, which are captured and uploaded through the website or the mobile application, in a three dimensional space, and defines the spatial relation-ship between them. In a third step of the photogrammetry algorithm, the coarse point cloud generated in the bundle adjustment step, dense point clouds are generated for further processing in a following step. In the final step of the photogrammetry known as the process of creating a scanned mesh, a "scanned-like" mesh is created based on the dense point clouds. Thus a 3D model that contain a surface of the three dimensional model of the earphone unit is created from the images of the ears of the user. At this point the textures from the images can also be applied, so the "scanned-like" mesh contains information of color on individual points on the surface. Thus the video or the images detailing the front and/or back structure of the pair of ears of the user is processed to create a 3d model of the user's ear via the photogrammetry process involving search and matching feature point in the plurality of images, creating a coarse cloud point, creating dense cloud point, running a cloud point cleanup process in order to create a smooth mesh from the cloud point etc. The 3d model is sent to the server 104 and confirmation notification is sent to the user either as a text message, email or app notification as a push message to the phone. If the process fails, then the images cannot be further used for creating the 3d model of the earpiece and a notification is sent to the user to repeat the capture. Then a plurality of mesh manipulations are performed on the scanned data, the mesh manipulation process includes a series of operation on the 3d model such as scaling, extraction, welding to another mesh, correction of non-manifold mesh, etc. In some cases, if the data captured by scanning the user's ear is poor due to either poor lighting conditions or complex geometry of the user's ears, certain areas of the user's ears may not have been scanned clearly enough for an accurate modeling of the user's ears using photogrammetry analysis alone. In these cases, in addition to utilizing a photogrammetry algorithm for creating a model of the user's ears, an additional step of adding statistical analysis may be taken to more fully and accurately create a model of the user's ears. A database of a plurality of human ear impressions may be created, large enough that statistically reliable data can be utilized to supplement any gaps in the photogrammetry analysis performed on the user's ears scans, in order to accurately model any portions of the ear for which the scan did not supply sufficient data. Based on the areas of the user's ear that were well captured by the scanning process, the statistical data-base can provide an accurate prediction of the shape of adjacent areas of the ear that may not have been clearly scanned, thus complementing the scanning process. For example, it may be difficult to fully capture the dimensions of the user's ear canal using a scanning method due to lighting conditions: here, complementing the scanned data with statistical data can yield a more accurate and fully developed model of the user's ear canal. Additionally or alternatively to the added statistical step, a trained human operator may also examine the scans/pictures/video images of the user's ears to assist in perfecting the modeling process. This operator can visually detect several feature points of the user's ears from different angles in the plurality of 2D captured images of the user's ears and compare these 2D images to the scanned mesh created by the photogrammetry algorithm. By identifying these feature points from the 2D images and identifying them on the scanned mesh model, the operator can refine the scanned model to improve on any areas that may not have been well scanned. The server 104 may perform the mechanical simulation and an acoustic simulation automatically or according to the user request. Furthermore, user-inputted data regarding ergonomics, Soundscaping preferences, aesthetic design, add-ons, may be factored into the modeling of the personalized earphone unit 114. According to these options as selected by user, the earphones shall be modeled accordingly to allow for the user's preferences. For example, the placement of the speakers may be optimized to the user's anatomy to most effectively direct the sound into the ear canal. The mobile application 108 and the web-site include a marketplace for allowing the users to select a custom design, type, color, material, add-ons, etc. That full list of action is listed in the marketplace module under fitting room, adds-on, listening room etc. The users can purchase the items from the marketplace associated with the mobile application 108 or the website. The mobile application 108 and/or the website may allow the users to store at least one amount in the online wallet associated with the user profile of the individual users. The users can make safe and fast payments for the services and selected marketplace items by using the online wallet. Other potential payment methods include Amazon, PayPal, Google Wallet, and secured credit card transactions.

### Ergonomics input and analysis:

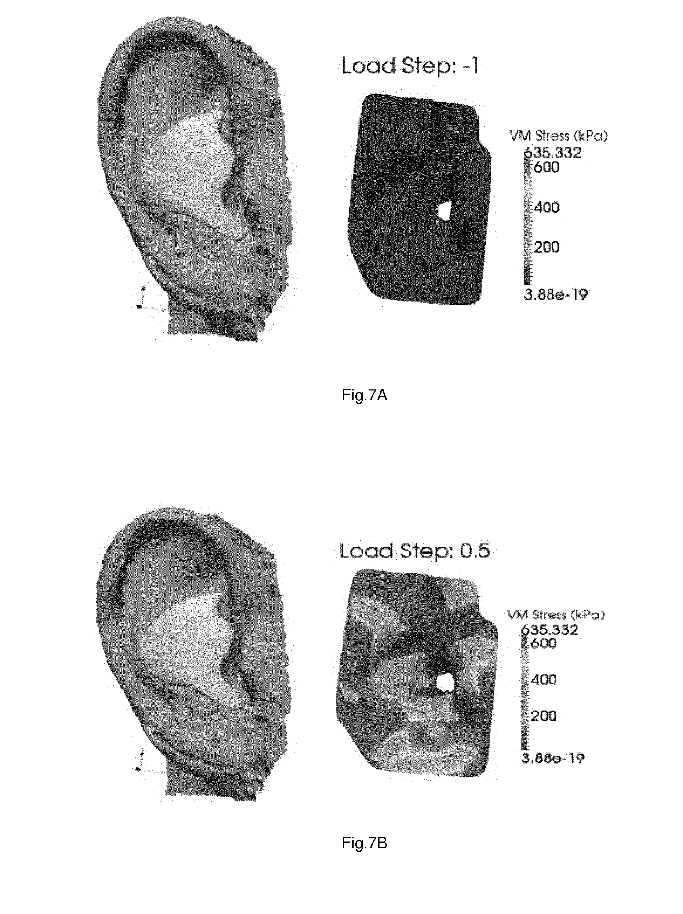

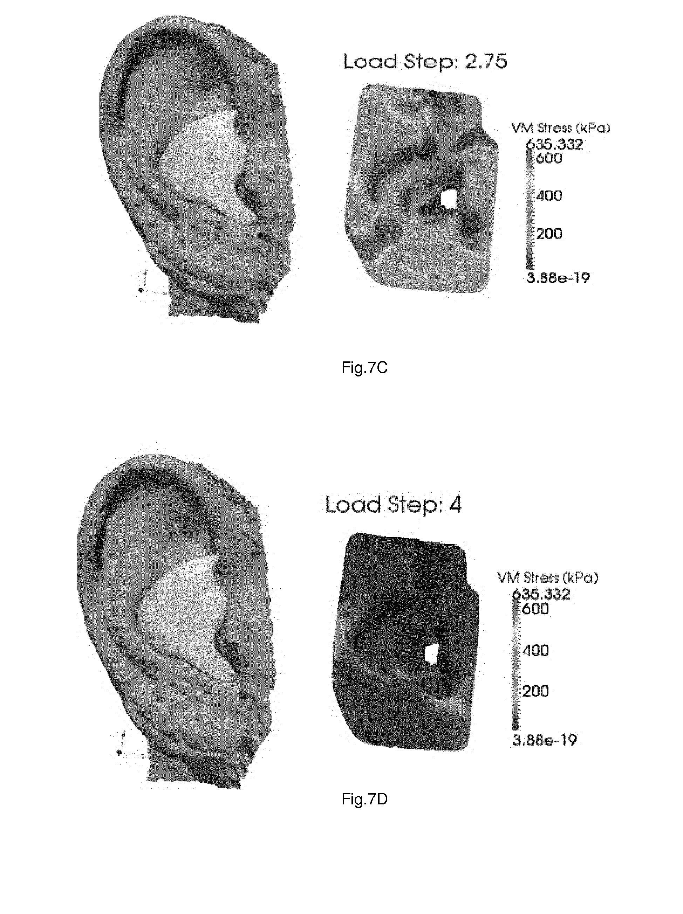

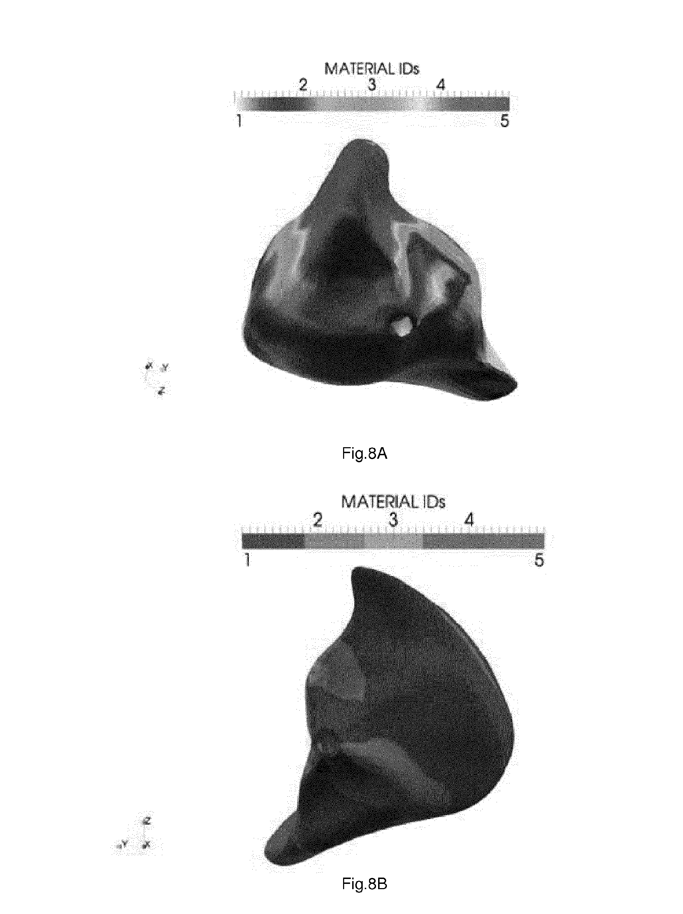

After the user-specific shape of the earphone is determined based on the 3D model of the user's ear(s) and the user's preferences, computer simulations are performed using a variety of simulation programs running on the server 104 to determine the contact stress between the user's ear(s) and the earphone. For simulation and analysis of the earphone unit 114, a small piece of material is added to the earphone unit 114 model to push the earphone unit 114 in the ear and the ear-phone unit 114 is then held in place only by the friction force. A load step is added to the simulation and analysis of the earphone unit 114 and the force on the earphone unit 114 is measured and studied using a series of simulations as shown in FIG. 7A to FIG. 7D. The user may have been prompted to input the activities in which he/she may be engaged while wearing the head-phones, and can specific percentage of the time he/she expects to be engaged in a type of activity. This may also allow for waterproofing to be taken into account, if needed for the user's activities, or to take into account designing the earphone unit to fit with a helmet if the user's activity/activities require the wearing of a helmet. The mechanical stress analysis using the simulation programs running on the server 104 helps to manufacture the personalized earphones 114 using soft, elastic materials in areas that is subjected to frequent friction or stress with the ears of the user. Such areas of high stress and the amount of force on an individual area of the ear may be determined using the simulation programs running on the server 104, which in turn helps to manufacture earphones unit 114 with a combination of materials including soft and hard materials. Hard materials may be at areas of the earphone unit 114, which is not subjected to stress and also acts as a hard shell for covering or protecting the plurality of electronic components of the earphone unit 114. FIG. 7A to FIG. 7D shows the sample images illustrating the force on the ears of the user for different types of loads obtained using the sample simulation programs running on the server 104. Thus the areas with minimum and maximum stress can be identified and the areas with maximum force may be manufactured with soft materials such as rubberized materials. Thus the comfort level of an individual user wearing the personalized earphone units 114 during a plurality of activities can be improved by using a combination of soft, elastic and hard materials. FIG. 8A and FIG. 8B shows the mechanical simulation diagrams illustrating areas of stress for which different materials may be used in the earphone construction. The mechanical simulation uses calculations on the forces active on the head to determine the strength and the direction of impact between the earphone and the ear. The simulation is used to map the earphone into areas according to the strength of the impact they are forcing on the ear. The earphone units is manufactured with specialized materials which makes them soft and at the same time sturdy to absorb the shock, and the rigid material may keep the earphone in place in the ear while in motion. In certain instances, the earphone units are printed on a multi-material 3d printer to utilize a mixing of soft and rigid materials and to allow different elasticity in the part. A plurality of mechanical stress analysis can be performed using simulation programs running on the server 104 to determine the areas of stress between the ear and the earphone module 114. The areas of stress on the earphone unit 114 where different types of materials used for the construction of the earphone units 114 are illustrated using different colored portions on FIG. 8A and FIG. 8B. The soft, elastic materials used in the construction of the earphone units 114 may absorb the stress between different areas of the earphone module 114 and the ears of the user. The use of soft and/or elastic materials at or near the areas of the earphone unit 114 subjected more stress during a plurality of activities allows the user to comfortably wear the earphone unit 114 when he/she is performing the plurality of activities.

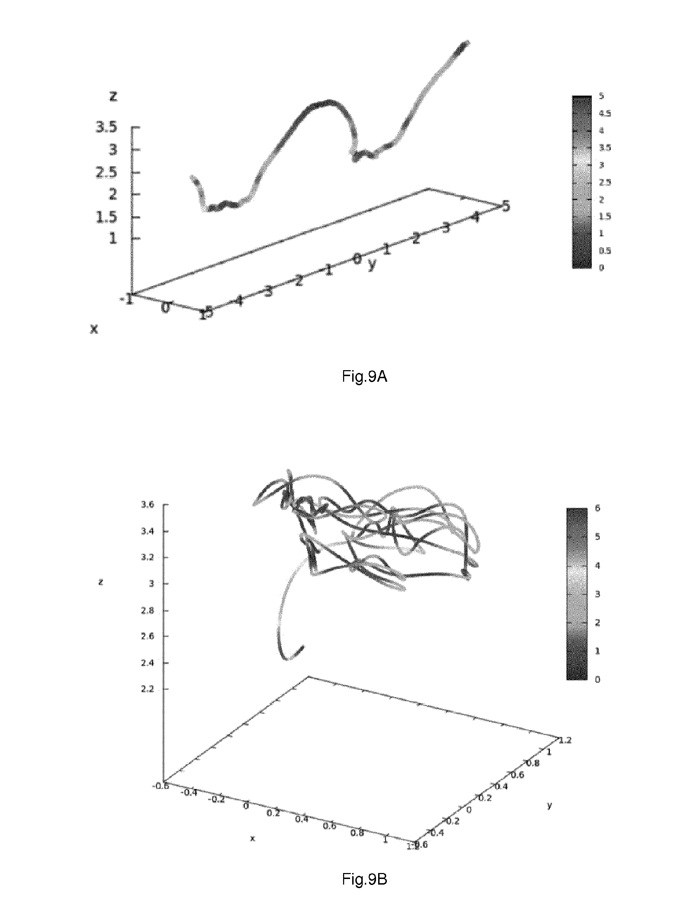

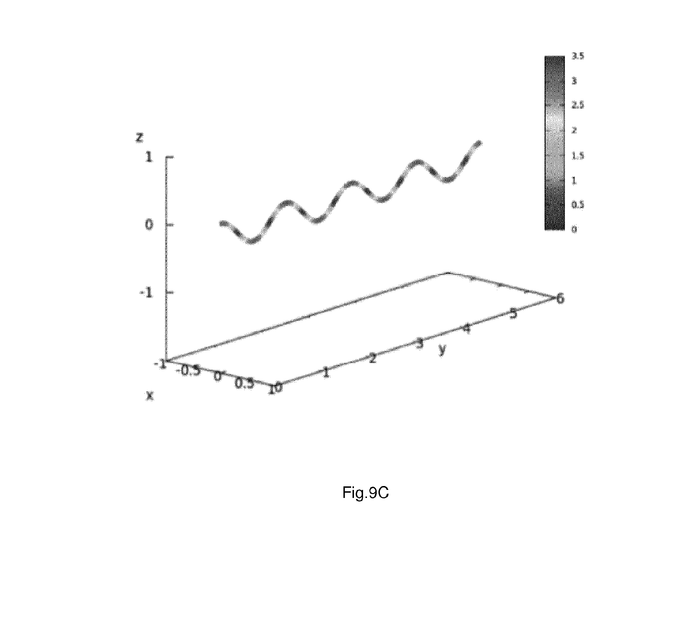

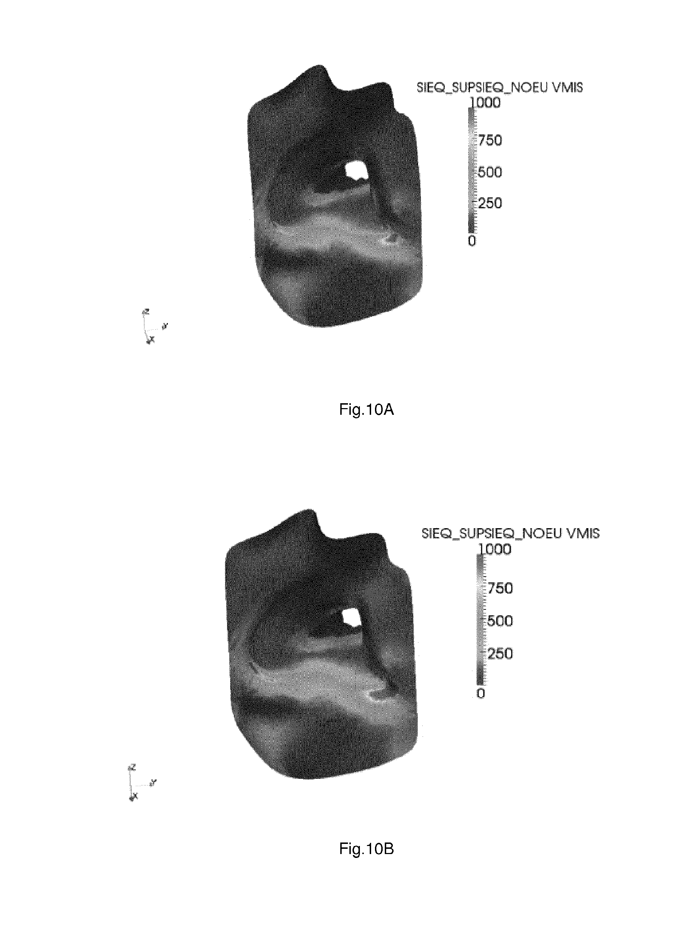

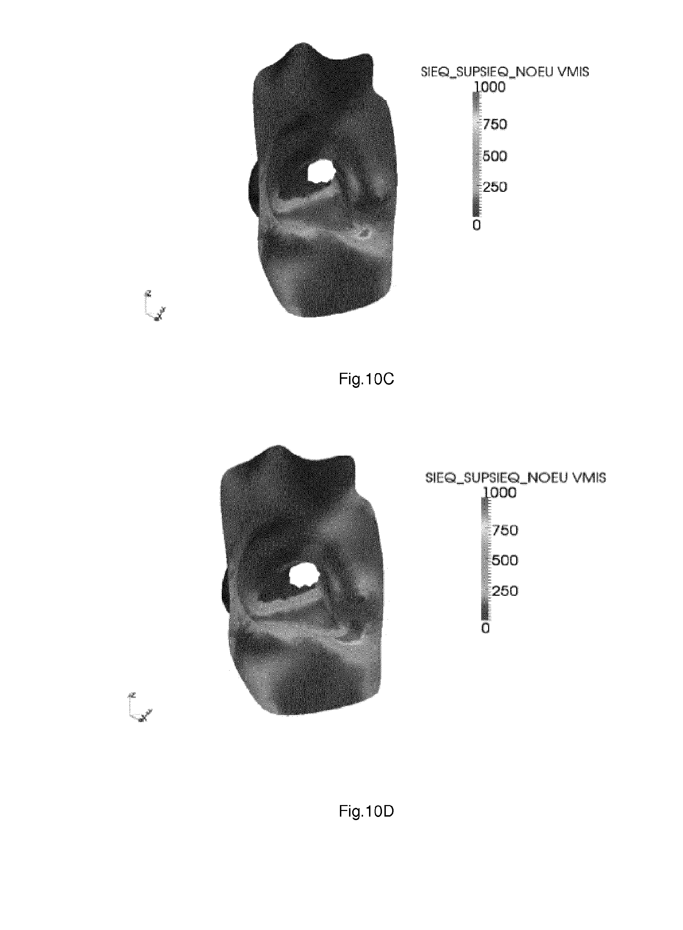

As a part of the analysis to design an ergonomically suited custom earphone unit for the user, the user may have inputted his/her activities during which he/she may be wearing the headphones. Motion capture analysis and biomechanical analysis is performed during the process of analysis for determining a movement of the head and to make adjustments in the manufacturing process. As a part of the analysis, the movement of the head of the user and the velocity and acceleration were measured. In one instance, motion capture can be conducted using multiple visible-red digital cameras interfaced with the real-time motion capture system. Marker trackers are placed on the research subjects, and coordinate systems are defined for the body to calculate a 3-dimensional movement. Additionally, motion capture databases may be utilized for pre-existing captured data, for example from the Carnegie-Mellon Graphics Lab Motion Capture Database. A biomechanical model is built using the 3D motion analysis data along with other means of analysis, possibly including analyses such as 2D video analysis, electromyography, force platforms, and/or foot pressure mapping. The testing includes variety of activity and the user may be prompted to self-report on his/her activities in percentages, including activities such as low-level activity of walking and domestic activities, moderate activity such as jogging, running, rowing, weight training etc., intense activity such as skateboarding, gymnastics, boxing, etc.. FIG. 9A to FIG. 9C shows the plurality of diagrams of trajectory of the head of the user during three different activities such as dancing, boxing and running respectively from the motion capture analysis. The trajectory of the head of the user and the associated acceleration is determined during the analysis for different types of activities such as dancing, boxing, and running. Hence the stability of the earphone unit 114 can be analyzed using these real world activities, which were simulated using the programs. The analysis isolates the forces active on the subject's head, and extracts the direction and momentum for a given time-step. In certain cases, a finite element model (FEM) of a human ear and the device is built in order to study the interaction between the two parts. A dynamic analysis is run and acceleration field of a prerecorded motion capture is applied to the model. FIG. 10A to FIG. 10B shows the maximum stress on the ears of the user wearing the ear-phone unit 114 by conducting dynamic analysis during a plurality of activities such as dancing and FIG. 10C to FIG. 10D shows the maximum stress on the ears of the user by the earphone unit 114 by conducting dynamic analysis during boxing performed using the dynamic simulation and analysis software. The stresses in the ear are used to evaluate comfort and stability of a specific design. The high stresses areas on the earphone unit 114 are smaller when rubber-like material capable of absorbing stress is used for the manufacturing of the earphone unit 114. Moreover, the earphone unit 114 is more stable when rubber-like material capable of absorbing stress is used since it is softer and has higher friction coefficient. Thus the earphone 114 units with soft materials having high friction coefficient may not fall down from the ears of the user while performing the plurality of activities such as dancing, boxing running etc.

In some embodiments of the invention, the personalized earphone units 114 can be printed using advanced 3d printing that enables a mix use of up to three materials in one build. The combination is seamless and allows creating a print that has elastic areas with rigid areas, or any spectrum between them. The change in material composition used for the printing of the personalized ear-phone units 114 is not necessarily visible if the elastic and rigid material is in the same color. The simulation identifies the areas in the earphone that prone to carry the loads from the activity, based on the unique anatomy of the user's ears and realistic dynamic data. An earphone material composition is calculated to create shock absorbent areas to maximize comfort as well as rigid areas to maintain stability and keep the earphones units 114 in place. The goal of the simulation is to create the maximum comfort for the user while at the same time making sure that the personalized earphone units 114 do not fall out of the user's ears during the self-reported activities. In certain instances, the ergonomics or the mechanical simulation process for designing the personalized earphone unit 114, which can be worn during activities, may recommend to the user to add an accessory such as safety wire / headband in order to ensure that the earphone does not fall out or that if it does, it may not be lost while performing the various specified activities. After the simulation process, the designs suitable to user's activities may be suggested to the user. In some other instances, the user may be asked to enter the height, weight, gender, and body build such as muscular, stocky, athlete, etc. to add mass to the motion capture data, during the simulation process. Then an exact model of the user may be simulated and processed to determine the best suited earphone unit model for the user. A more advanced simulation process includes friction analysis and also takes into account the material properties for the personalized earphone unit 114. The computer implemented system 100 may ask the user to specify his/her sweat level on a range from 1 to 10, or to specify if he/she engages in water sports, in order to add those factors into the friction analysis to ensure that the earphone units may not fall off while performing the activities.

Soundscaping can be adjusted to personalize the earphone units 114 for the users. The user can determine how much environmental sound may be allowed to the ear canal. Embodiments of the invention may offer at least two potential levels of Soundscaping. For example, these levels may include: (1) physical proper-ties of the earphone, such as adjustment of the hermetic seal to allow more or less environmental sound in, for users who don't like the feeling of the earphones creating pressure to the ear canal; (2) Passive Soundscaping in which a tunnel that directs air from outside of the earphones into the ear canal to allow mixing of speaker sound with environmental sound, in the middle of the tunnel there may be an adjustable aperture or diaphragm that may control air flow and can be adjusted by the user electronically - this allows the user to set the environmental sound level whether or not the device is on or off and whether or not the device is playing music/sound files, the advantage being that the user can use the device as an earplug without consuming battery power or the user use the device as a fashion accessory and still be able to hear environmental noise; and (3) Active Soundscaping in which a microphone connected to a microprocessor in the earphones or in the mobile device analyzes the environmental sound and determines, according to user specifications, the levels and types of environmental sound to filter or allow.

### Preproduction Soundscaping Options

Before the user receives his/her earphones (i.e., during the time in which the user is designing the earphones to suit his/her preferences for fit, appearances, add-ons, etc.), the user can make several decisions regarding the physical properties of the headphones based on his/her Soundscaping preferences. While designing his/her earphones, the user may choose from a variety of speaker options, including the number of drivers and their physical settings. While making these options, the user may be provided with sound samples so that he/she may choose the options most suited to his/her sound preferences. During the design phase, the user may also be able to specify how snugly the earphones may fit into his/her ear canals. If the user has chosen a design for his/her earphones that does not create a tight seal in his/her ear canals based on his/her comfort preferences, low frequencies sounds (i.e. bass sounds) suffer from a bigger leak than the higher frequency sounds. To counteract this, the user can choose if he/she would like to adjust the sound driver to select a driver that pushes the low frequency sound stronger.

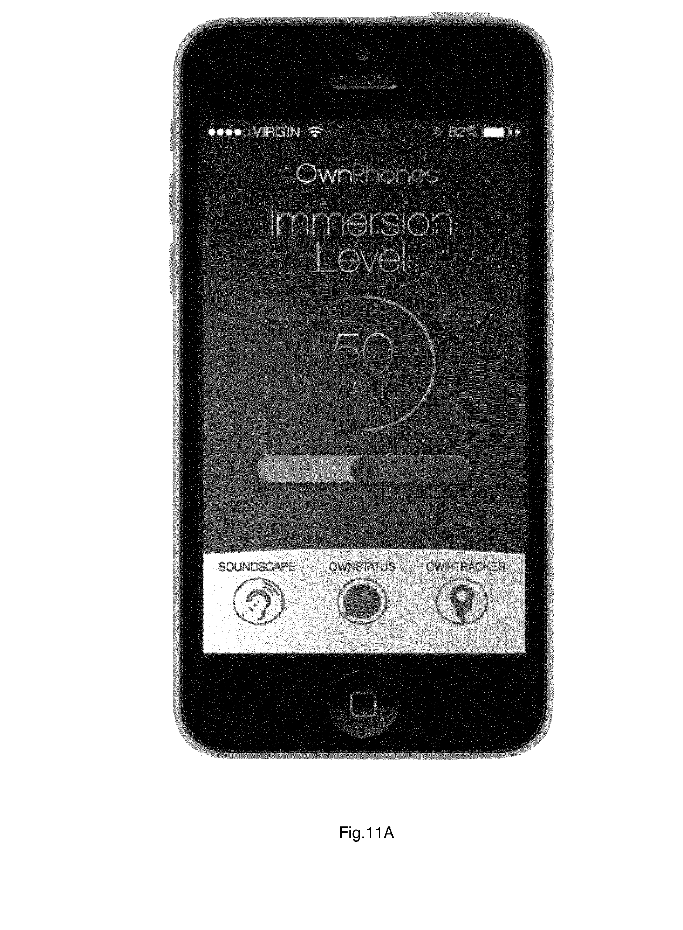

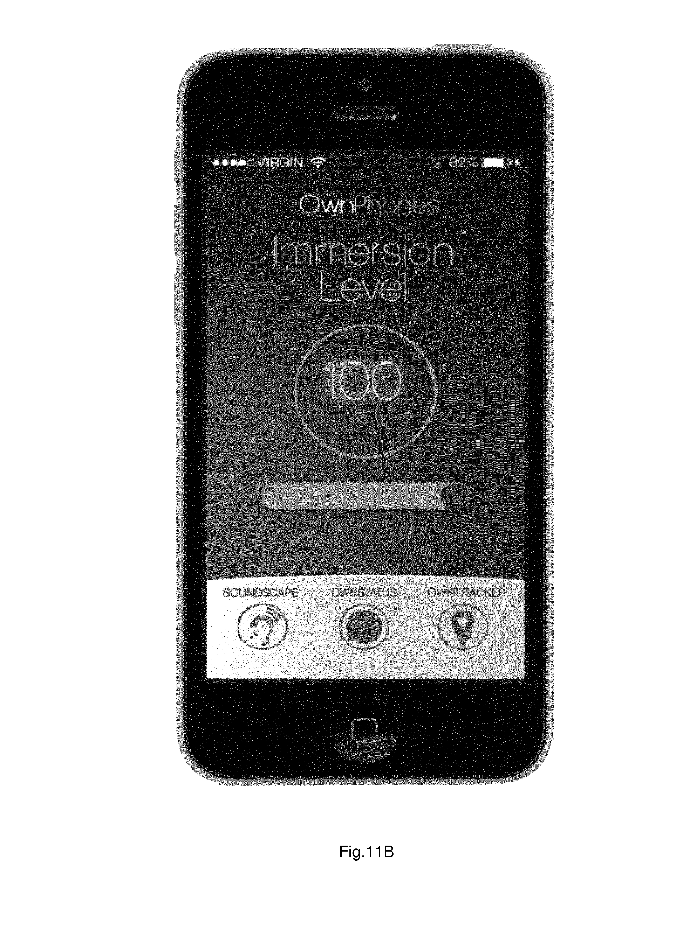

FIG. 11A and FIG. 11B illustrates screen shots of a user interface of the mobile application 108 showing an immersion level for the user, which can be set by the user by adjusting the slider on the user interface of the mobile application 108. During the design phase the user may have access to a "soundroom" option area. Here the user can simulate how the earphones may sound mixed with environmental sound. The simulation may allow the user to listen to pre-recorded environmental sound, such as: subway ride, busy street, quiet street, office environment, gym, bus ride etc. Then the user could mix in music provided by the service, or the user's own music. The user may be able to slide the Immersion level, which is shown in FIG. 11A, a slider on a user interface of the mobile application 108 that may allow the user to choose the amount of environ-mental sound he/she is interested in, and hear a simulation of how the earphone may sound. The user interface of the mobile application 108 includes immersion level slider as shown in FIG. 11A and FIG. 11B that allows the user to adjust the immersion level slider from zero percentage to a hundred percentage according to his/her requirement. A user may also be able to play intrusive sounds such as a police siren, knock on the door, buzz on the door, somebody saying "excuse me sir", etc. The user can simulate adding those sounds to the 'music + environmental' sound to hear how his/her personalized earphone unit 114 may sound.

### Postproduction Soundscaping Options

In addition to the option of choosing from a variety of physical properties of the earphones such as speaker and driver options during the user's earphone design phase (i.e. during pre-sale/before the user receives the custom fitted earphones), the user can also further adjust his/her Soundscape preferences after he/she has received the earphones (i.e. during post sale/after the user has received his/her personally fitted and designed earphones unit). One example of post-production Soundscaping option is Passive Soundscaping, which may also allow the user to control the Passive Soundscaping tunnel aperture size with the mobile application 108. The adjustment of the aperture may accommodate how much environmental sound the user would like to be allowed to penetrate to the ear canal. This adjustment may hold whether or not the music is playing, allowing the user to adjust environmental noise when desired, such as working or sleeping. The user may be able to slide the Immersion level slider, a zone on a user interface of the mobile application 108 or application website that as shown in FIG. 11A and FIG. 11B, which may allow the user to increase or decrease the amount environmental sound that he/she is interested in.

Additional post-production Soundscaping options include adjustment of driver settings, within the driver's range capabilities, by varying the resistance values to the drivers and adjustment of equalizer settings. Driver setting adjustments and equalizer setting adjustments can be made through the mobile application 108 or application website. Users can configure his/her preferred equalizer for the personalized earphone unit 114. Users can choose preset options, such as an equalizer that is designed for specific genre, or sounds preference. Also users can draw their own graph for the equalizer. User can use the mobile application 108 or application website to scan the music on their device, or allow access to their listing history through their music service such as Pandora, RadioFM, Spotify, etc. Users can adjust these driver settings and equalizer settings as often as he/she would like through the mobile or website application interface, and the user may save particular setting profiles based on situations in which they would like to use those settings again. The user may opt to make adjustments through the mobile application 108 or application website to adjust the sound drivers to amplify high or low frequencies while the passive Soundscaping is open, since opening up or closing up the passive Soundscaping aperture may also affect high and low frequencies. Similarly, the user could perform a hearing test through the mobile application 108 or the website and adjust the frequency response for equal loudness.

Active Soundscaping include a "Real World Notification" system provides users with another level of post-production Soundscaping control options. Through the application website or the mobile application 108, the user can specify what elements of environmental sounds he/she wants to let through or filter while using the personalized earphone unit 114. For example he/she can choose to filter out traffic and airplane noise, but filter in "real-world notification" sounds such as knocks on the doors, fire alarms, sirens, vehicle horns etc. This provides the user wearing the personalized earphone unit 114 with more awareness of his/her environment while listening to music. Users can create and save "Real World Notification" profiles, so that when the user is within a certain distance of a pre-saved "Real World Notification" Soundscape, the remembered Soundscape settings may be automatically applied.

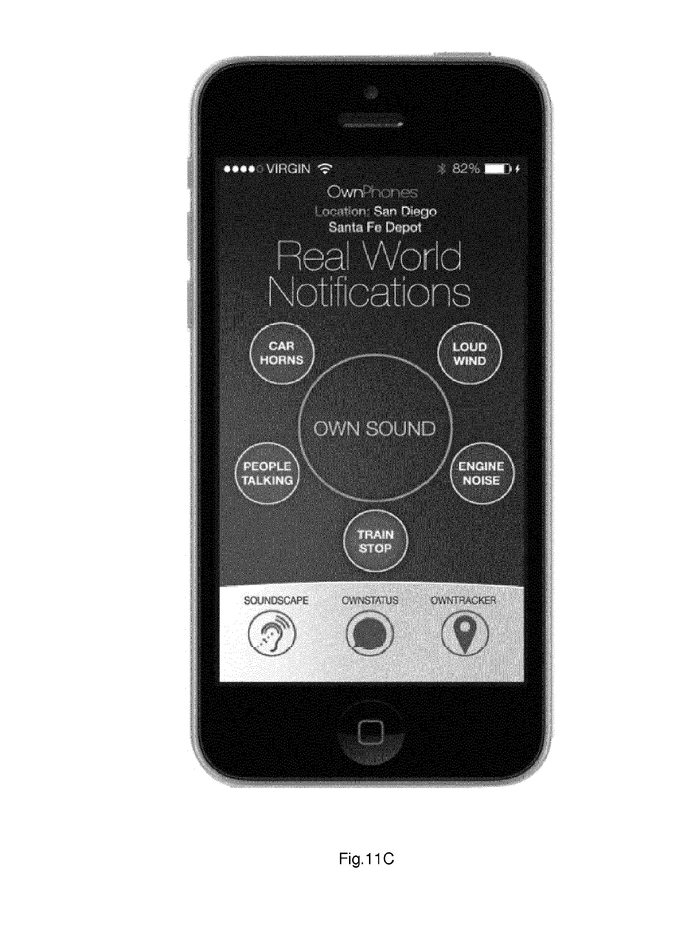

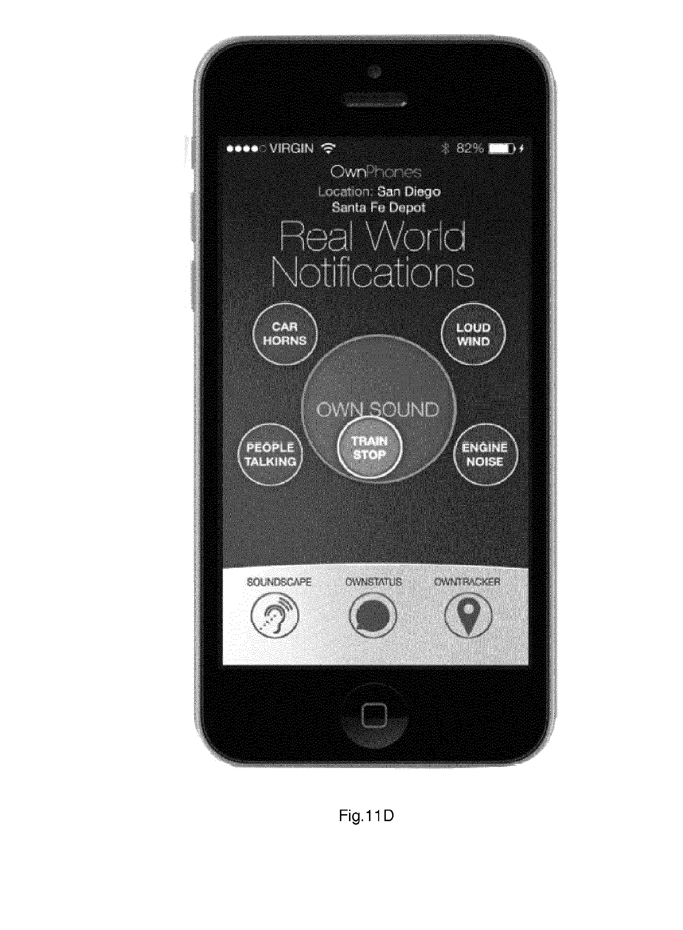

Regarding Real Word Notifications, the user may be able to add to and refine the sounds he/she wants to filter. Upon user's first use of the Real World Notification sound filtering system, the mobile application 108 may ask the user for his/her location and suggest corresponding sound options based on that location that the user may want to filter. For example, FIG. 11C and FIG. 11D shows the screenshot of the Real World Notification adjustment screen that may be found within the mobile application 108 or application website. This screen shot shows several examples of Real World Notification sounds such as car horns, engine noise, people talking, loud wind, train stop, etc. that may be suggested to a user who is walking around busy city streets. During use of the earphones, the earphones can also pick up additional sounds from the user's environment that are not recognized or do not fit into the pre-existing listing of Real World Notification sounds listed on the Real World Notification mobile application 108 screen or application website screen. The user can then enter an identification name/label for this new sound or change an existing label and it may then be listed along with the other Real World Notification sounds that the user may choose to filter out or to allow to be heard. The Real World Notification library or database of Real World Notification sounds can also be refined and added to by the entire community of earphone users. As a user adds new sounds to the Real World Notification library/database, other users can choose to incorporate these sounds into their own Soundscaping preferences for filtering. Sounds added to the Real World Notification sounds library/database can also be tagged by geographical location ("geotagged") such as "San Diego International Airport," "East Mesa College," "Mike's Pizza" at a particular address, or tagged by general location type descriptions, such as "coffee shop", "university," "stadium," "city street,", etc. so that users in the same or similar geographical locations or location types can choose to filter sounds that they may encounter in their shared environment. When the user is within a certain distance of a pre-saved Soundscape, the remembered Soundscape settings may be automatically applied. Additionally, the user has the option of receiving a mobile phone notification through the mobile application 108 upon the earphones picking up a pre-determined Real World Notification sound. For example, the user may opt to receive a mobile phone notification if the earphones detect police sirens, or any other sound from the Real World Notification sound library/database.

The mobile application 108 or website associated with the computer implemented system 100 for providing the personalized earphone unit 114 allows for a plurality of user interfaces that may provide the user with the ability to personalize the earphones unit, choose designs, select add-ons to the earphones, as well as interact with other users for design sharing. These interfaces include a Marketplace module, Design module, and Augmented Soundscaping module etc., which are explained below. The Marketplace page of the mobile application 108 and/or the website may feature highlights from the different areas/modules of the website product display area, style collection area, bestselling designs, most liked designs, most popular add-ons, etc. The product display area displays the different types of products, add-ons, and matching accessories that the user can choose from. If relevant, those products may be custom fitted according to the user ear scan. Customization options include wired/ wireless earphones, in-ear earphones, on-ear earphones, Bluetooth capability, in-ear headphones, ear-buds, ear buds with in ear/on ear clips, neckband earphone, personal monitor, mobile headset, earplugs, earphones for wearable devices such as Google glass and more. Additional add-ons include LED lights to indicate level of desired interaction, for example, red means don't disturb, green means Ok to interrupt, and yellow means interrupt only for important matters. The user can opt to sync the LED red/green/yellow indicator lights with their social media account status. For example if the user may choose to sync the LED lights with their Gmail account status i.e. if their Gmail chat status is "Available," then the green LED may be displayed on the earphone unit, if their status is "Busy", the yellow LED may be displayed, and if their Gmail chat status is "Unavailable," then the red LED may be displayed. The same can be done for any other social networking account that allows its user's to set their availability status, such as, but not limited to, Facebook, other electronic messenger or chat clients. Another add-on feature may include sleep features such as built in soothing sounds or white-noise to help the user fall asleep, sleep tracking technology to monitor the quality of user's sleep, and smart-wake up sounds/technology to wake up the user at the optimal time based on tracked sleep cycles. The user can choose whichever customizations he/she desires. Accessories a user may choose include matching jewelry such as earrings or bracelets necklaces or charms, masks, bags, purses, watches, eyeglasses, headpieces, apparel, and even apparel. Furthermore, an additional option may be integration of the accessories and/or apparel with the earphones. For example, the personalized earphone units 114 may be designed to appear like jewelry and/or may attach via fabric or other means to a dress/shoulder strap or other piece of apparel. One more option would be that the user can opt to receive blank, or white, or other solid colored, earphone units to customize/decorate himself/herself, for example with various types of compatible paints, polishes, decals, or attachable decorative items. Before checking out of the Marketplace, if the user didn't choose the style for his products he/she can transfer to the style collection area or to "Design your own" area. Additionally, user may communicate with other users and/or registered designers to select one of their designs. This feature may be especially useful for groups or teams who wish to have matching earphones. Regarding designers, individuals or companies may register with the mobile application 108 or website to enable them to create designs to be marketed in the marketplace.

In regards to add-on selections: the computer implemented system 100 can be used for producing personalized wireless earphone units that work based on a Bluetooth connection between the earphones at left and right ear of the user. The product customizing area allows the users to select add-ons to add functionality to the personalized earphone unit 114, which includes, pulse sensor for heart rate sensing, accelerometer to track movement, flashing LED for users who jog at night and want to add extra visibility, sleep monitoring technology (motion sensor/accelerometer to track sleep quality), sleep sounds/white noise, smart wake-up technology, LEDs to signal desired interaction level, for example red indicates "do not disturb", yellow signals "disturb only for important matters", or green may indicated "I'm open for all interruptions/interaction", or LEDs with a digital display so that the user may be able to display messages to those around him/her. For the sleep technology options, user may be asked if he/she plans to wear the ear-phones while sleeping. Another option would be that the LED can be made active by walking or running and may work only when the music is playing to offer hassle-free turn on-off. There are at least 4 types of LED Options: (1) interaction level, (2) visibility with motion or music, (3) matrix LED for text, (4) OLED for higher level of graphics, which is more like a cell phone screen.

Additionally, the personalized earphone unit 114 can be provided with at least one microphone for making calls and for use in augmented sound module. During the design phase, the user may be asked if he/she plans to use the earphones during swimming or other water sports. The personalized earphone unit 114 can be made water resistant by adding a nano-coating on the ear-phone such as Liquipel to protect liquid damage. Additionally, the user may be asked if he/she plans to wear the earphones with a helmet, such as a sports helmet, motorcycle helmet, etc. so that the earphones may be ergonomically designed to best fit for the user during that activity. The personalized earphone unit 114 can have custom-fit ergonomics for the user ear. Shock absorbing areas that may be under a lot of stress in the earphone may be mapped, and an elastic material may be used to act as a shock absorber thereby improving the comfort and durability of the personalized earphone unit 114.

The mobile application 108 or website also provides a fitting room service for allowing the users to select a level of fitting to the ear of the user desires i.e. tight, normal or loose. Users can choose to add the ergonomics adjustments - i.e. can run a mechanical simulation on the ear model and calculate the zone that are prone to shock and can print them in softer materials. Further the mobile application 108 associated with the computer implemented system 100 for providing the personalized earphone unit 114 provides at least one design area where the users can choose the material that may be used to 3d print their product or any part of the product. These materials can include plastic, rubber-like material or metal or a combination of material, sometimes called "digital material". The user could choose what areas of the earphone may be made out of rigid, or soft, rubber like material. The user can also choose the outside appearance of the personalized earphone unit 114, i.e. the color and the graphics on the personalized earphone unit 114. The user can draw area of the earphone that will be printed in different color/ material. The user may be able to choose any pre-configured shapes or define those shapes on the earphone, in order to apply different color/material on them. The user can share those shapes with other users through the mobile application 108 and the website and through any social networking means such as Facebook, Twitter, Google +, Tumblr, etc. integrated with the mobile application 108 and the website. The user can add several add-on elements and that may be assembled into or onto the 3d printed shell of the personalized earphone unit 114. Those elements can enhance functionality or the visual appearance of the earphones, such as gemstones, LED light, holographic print, wood veneer, etc. The 3d model of the personalized earphone unit 114 may change according to embedding mechanism of that specific element to allow secure and quick assembly. For example, a socket may be added to the design to allow quick assembly of gemstones, a mounting mechanism for LED may be incorporated into the inner part of the shell, flat or semi flat area may be define in the design to allow 2d materials such as veneer or a print to be placed in the inner shell. Once the user finishes the design his/her earphone, he/she is given the option to share his/her design with the rest of the community of users. The user can opt to become a registered designer to also sell those designs through the marketing platform associated with the mobile application 108 and the website with other users, and anytime that design is sold, the user can receive payment through the platform of mobile application 108 and the website. The sharing of the designs may allow the users to publish the designs with his/her own team members or he/she can create new teams or groups such as sport teams such as local high school or professional sport team or any other team, game developer, music band, work groups, recreational teams, etc. The users can also share their designs with anyone who is not part of the group. User creating the team/band, can decide if he/she wants to allow sharing with only members of the group by invitation, or share it with fans for free or for sale. Users can send a few designs either his/her designs or other designs for his friends and can ask them to help him/her to decide which product he/she should buy, thereby he can create a voting or rating for a particular design of the custom designed personalized earphone unit 114 and can increase the chances of marketing his/her design among other users. User can vote or comment on a plurality of designs and the invitation for voting or for providing feedback can be send by email, text message, Facebook, app notification, etc. or other social networking tool.

The mobile application 108 or the website may include a style collection area that may display different styles for the products, created by users and registered designers (i.e. "community members"). The area includes styles designed by the users and/or registered designers. The area may also include styles shared by the community, i.e. designs that were made by other users, as well as the possibility of designer brands. The community members and designers can join in one or more designers programs, which may be like apple developer program where the plurality of users can register and can upload a variety of designs of the earphone. There may be sections such as most popular, most shared, new, highlights etc. within the style collection area allowing the users to easily select a desired design of the earphone model and the add-ons. A matching accessories section may offer matching accessories to the style chosen by the user. User can choose matching accessories such as bracelets, cufflinks, earrings, necklaces, pendants, rings, bags & purses, belts, glasses, wallets, and/or apparel. Or he/she can even select from home decor, art or miniature that may carry the same style as his earphone model. A check-out section allows for paying for the products received through the mobile application 108 or the website. The check-out section supports various methods such as Amazon checkout, PayPal, Google wallet, or the user can use online wallet amount associated with his/her profile, or he/she can redeem coupons or credits received from the mobile application as gifts or manually entering credit card information, billing and shipping address.

The 3D printing module unit may utilize the available 3D printing technologies for printing the personalized earphone unit 114 such as from Stratasys Objet500 Connex3, DMLS (Direct Metal Laser Sintering) for Metal printing and SLS (Selective Laser Sintering), QuickCast, FDM. The system 100 utilizes other digital fabrication technologies such as CNC, laser cutter for fabricating natural element such as wood or gemstones, or 2d design elements such as veneer, prints, and holographic images. Additional post-processing options were described above, in the detailed descriptions of FIG. 5A and FIG. 5B section.

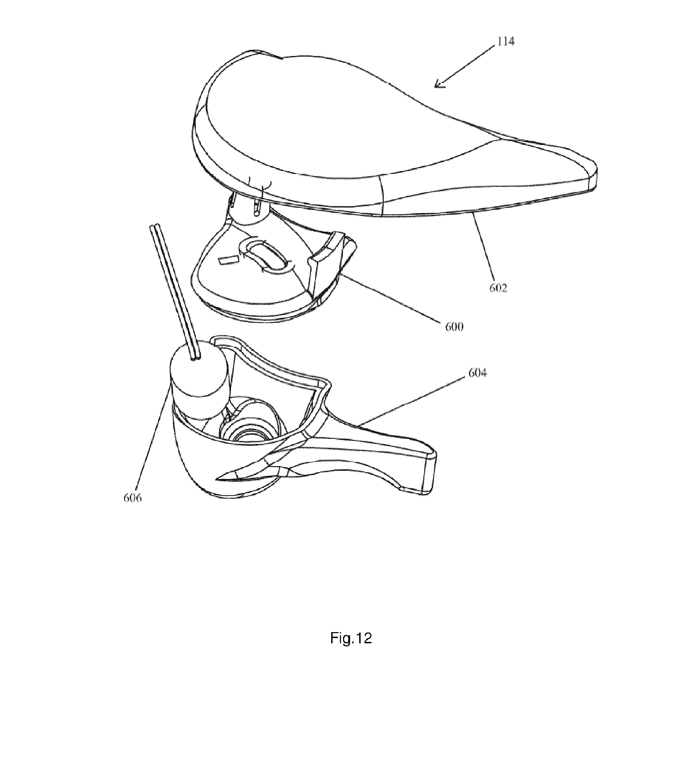

According to some embodiments of the present invention, the personalized earphone unit 114 is constructed by assembling a plurality of three dimensional printed parts, which is generated by processing the at least one video and/or a plurality of images of the ears of the user obtained by using the mobile application 108 running on the plurality of electronic communication devices 102. The server 104 processes the plurality of information received from the mobile application 108 and a plurality of information obtained by performing a plurality of simulation and analysis by a plurality of software, which may be running on the server 104. The plurality of information received from the mobile application 108 includes a plurality of options such as, but not limited to, immersion level, real world notifications, etc. selected by the user from the mobile application 108 and/or the website. FIG. 12 shows a perspective view of the personalized earphone unit 114 formed by assembling by at least three custom printed parts using the three-dimensional printer unit 112. The personalized earphone unit 114 shown in FIG. 12 is constructed from a cap 600 for the earphone unit 114, an interchangeable unique bezel 602 that can be attached to the cap 600 for use as a cosmetic bezel, and a base 604 customized to match with the anatomical features of the user. The interchangeable unique bezel 602 that can be attached to the cap 600 of the earphone unit 114 can have a variety of designs that can be selected by the user. The user can select his own designs or he/she can select a plurality of designs provided by a plurality of third parties. In some instances, the users can select a plurality of designs for the interchangeable bezel 602 from the mobile application 108 and the website offering the custom interchangeable bezel 602 designs. The interchangeable bezel 602 can be removably attached to the cap 600 of the earphone unit 114 using a plurality of attachment means such as, but not limited to, clips, pins, adhesives etc. Thus the user can try with a variety of interchangeable bezels 602 for giving unique look and feel to the personalized earphone unit. The base 604 portion of the personalized earphone unit is printed using the three-dimensional printer unit 112 by considering a plurality of the anatomical features of the ears of the user for forming a custom and comfortable match with the ears of the user. The base 604 and the cap 600 of the earphone unit 114 are having provisions for placing the plurality of audio electronic components within them to form the personalized earphone unit 114. The base 604 and the cap 600 of the earphone unit 114 include grooves for securely placing the plurality of audio electronic components such as the speaker 606 deposited within the base 604. The base 604 and the cap 600 can be attached together after placing the plurality of audio electronic components inside them using a plurality of attachment means such as, but not limited to, pins, clips, adhesives and any other locking or attachment means. In some other instances, the attachment means for connecting the base 604 and the cap 600 is selected such that it allows for forming a water resistant earphone unit 114, wherein the attachment means forms a tight seal between the base 604 and the cap 600, securing the plurality of audio electronic components placed within it.

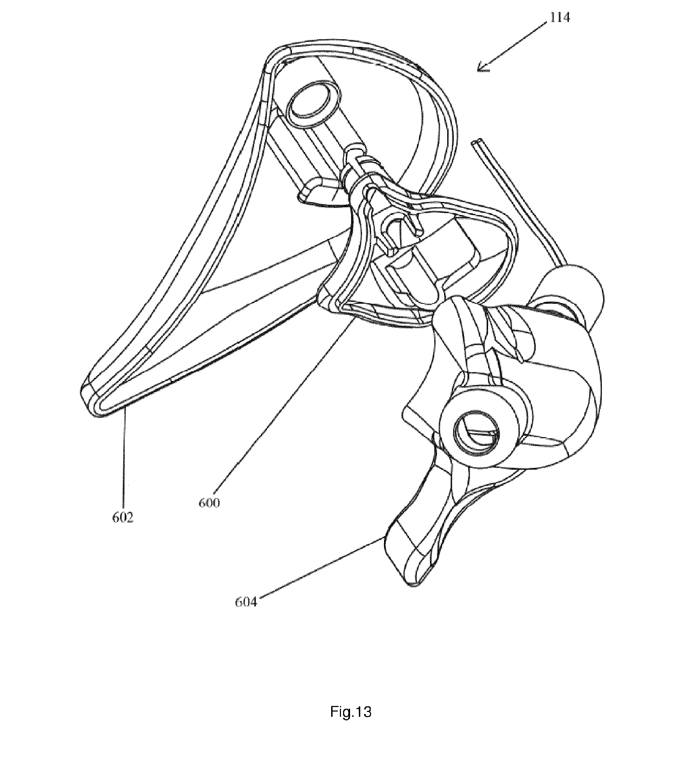

FIG. 13 is a perspective view of the personalized earphone unit 114 formed by assembling the at least three custom printed parts such as the interchangeable unique bezel 602, the cap 600 and the base 604, which are printed using the three-dimensional printer unit 112. The plurality of audio electronic components such as the speaker 606 is securely placed inside the cavity formed by the cap 600 and the base 604 portion of the personalized earphone unit 114. The size and shape of the interior portion of the cap 600 and the base 604 portion of the personalized earphone unit 114 is designed such that it allows for the plurality of audio electronic components including the speaker 606 to be conveniently oriented and tightly placed with in the cavity. The speaker 606 is arranged in the cavity of the base 604 portions by orienting towards an opening leading to an interior of the ears of the user. The base 604 of the 3d printed earphone unit 114 is having openings leading towards the interior of the ears of the user for placing and orienting the speaker 606, thereby effectively delivering the sound produced by the speaker 606 directly to the inner ear. In some instances, only the cosmetic interchangeable unique bezel 602 is visible from the outside, when the user attaches the personalized earphone unit 114 to his/her ear. Thus the user can customize the personalized earphone unit 114 by attaching a variety of interchangeable unique bezel 602 on to the cap 600 of the earphone unit 114. The variety of interchangeable unique bezel 602 attachable on to the cap 600 may have different colors, designs, logos, symbols, letters, etc. for providing unique identity to the wearer. For example, a group of students belonging to a single college, university or school, a plurality of employees of an organization, plurality of members of a particular team such as cricket, football etc. can use personalized earphone units 114 with similar logo, design, color, letters etc. This may give unique identity to the users of the personalized earphone units 114.

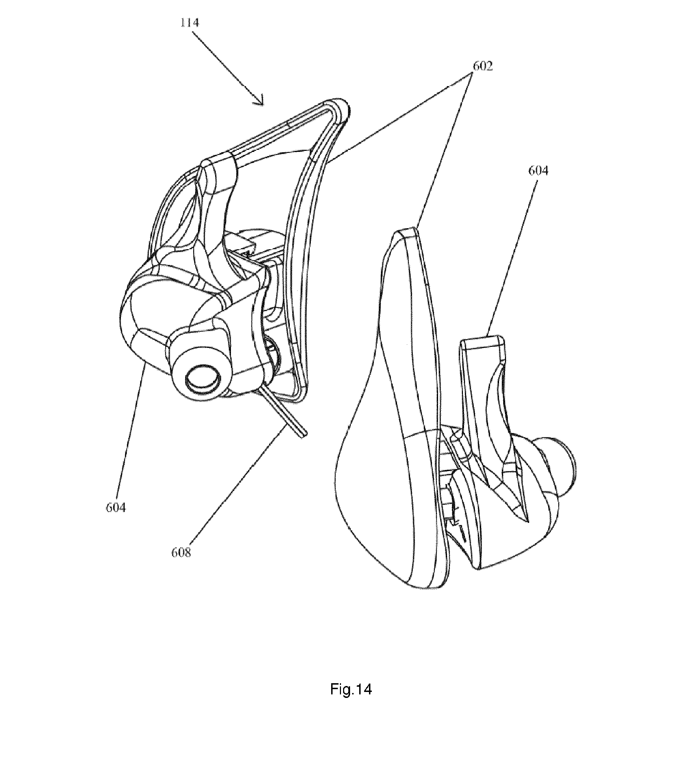

FIG. 14 is a perspective view showing a pair of assembled personalized earphone units 114 from the at least three custom printed parts such as the interchangeable unique bezel 602, the cap 600 and the base 604, which are printed using the three-dimensional printer unit 112. The finished earphone unit 114 may be featuring the earphone speaker diaphragm securely placed within the cap 600 and the base 604 and directing towards the opening leading towards the ear canal of the user for delivering high quality, lossless audio to the ears of the user. In some embodiments, the earphone units 114 are available as wired and wireless devices. In wireless earphone units 114 the audio data may be transferred to it using wireless means such as Bluetooth. In case of a wired earphone unit 114, the plurality of electronic components secured inside the cap 600 and the base 604 is tethered for receiving audio signals. Here the wire/wires 608 attached to the plurality of electronic components secured inside the cap 600 and the base 604 of the earphone units 114 is tangle free for hassle free use by the users. An exterior side of the cap 600 forming the assembled personalized earphone unit 114 may have a shape confirming to the shape of the antitragus of the ears of the user. This shape of the exterior side of the cap 600 allows the personalized earphone unit 114 to be comfortably fit inside the ears of the user. The antitragus of the ear may be in contact with the exterior side of the cap 600 having the shape confirming to the shape of the antitragus of the ears of the user. Hence the antitragus portion of the ear secures the personalized earphone unit 114 inside the ear without falling while performing a plurality of activities by the user.

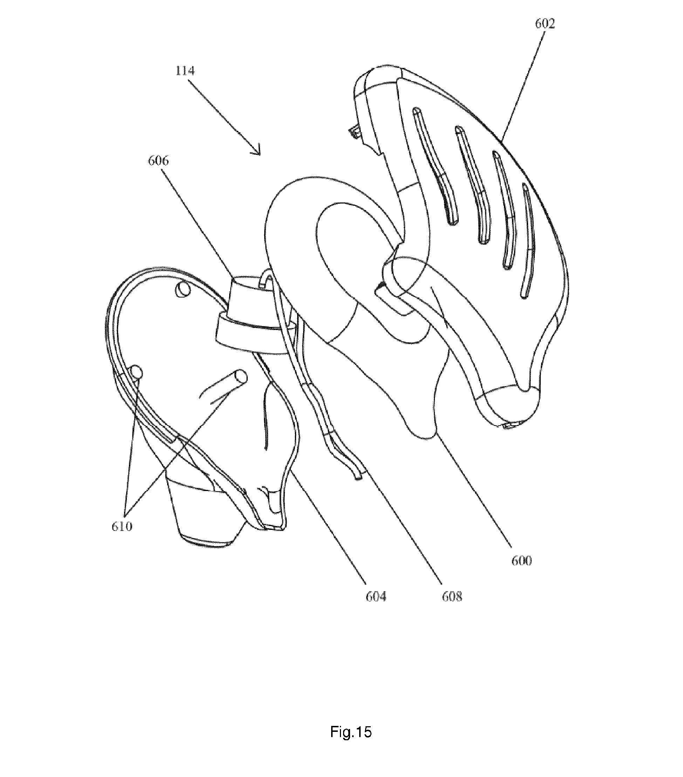

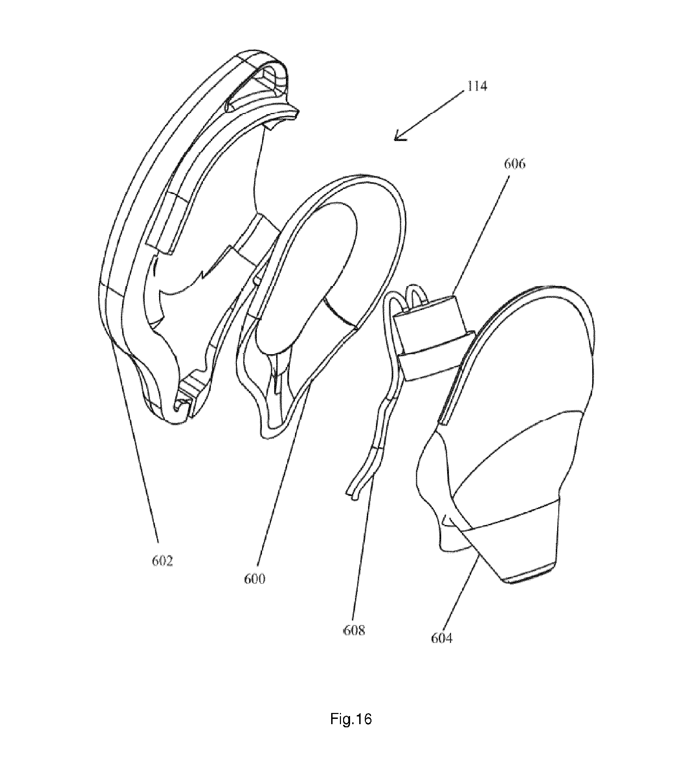

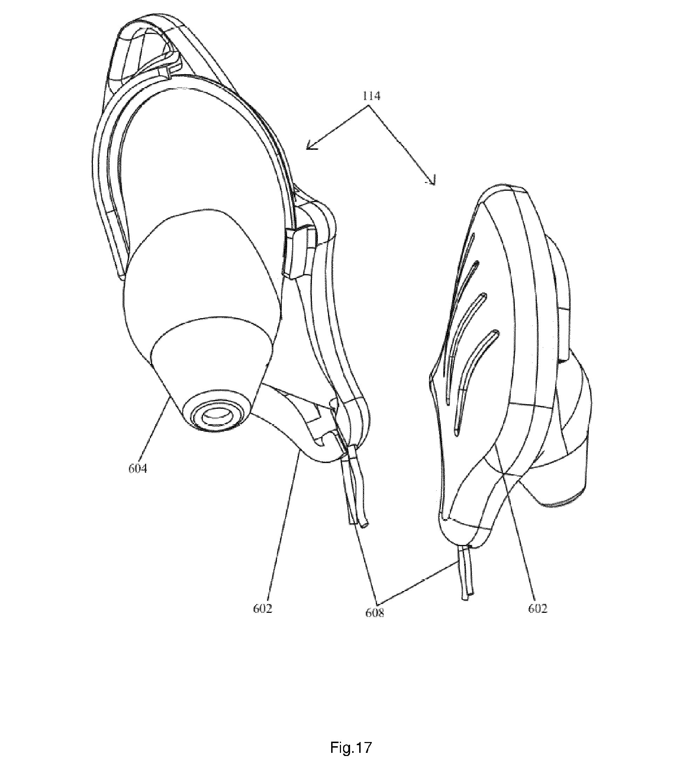

FIG. 15 and FIG. 16 is an exploded view of the personalized earphone unit 114 showing a plurality of 3d printed parts, such as the interchangeable unique bezel 602, the cap 600 and the base 604, which are printed using the three-dimensional printer unit 112, of the wired/tethered personalized earphone unit 114. In some embodiments, the base 604 portion forming a part of the personalized earphone unit 114 can be selected by the user. The users can select a desired base 604 to attach with the cap 600. The base 604 is available with a plurality of designs such as having different types and shapes for openings leading towards the inner ear of the user. The users can attach the custom base 604 for the personalized earphone unit 114 with the cap 600 using a plurality of attachment means such as clips, pins etc. In some embodiments, the mobile application 108 or the website allows the users to select desired model of the base 604 for attaching to the cap 600, securely enclosing the plurality of audio electronic components including the speaker 606. In some embodiments, the users can design desired base 604 portion from their own material and designs and can be attached to the cap 600 for realizing the personalized earphone unit 114. The wires 608 is connected to the plurality of audio electronic components including the speaker 606 and securely brought out through an opening on the cap 600. The interchangeable unique bezels 602 having a variety of designs and shapes and can be easily attached to the cap 600 using mechanical attachment means such as, but not limited to, snaps, clips, etc. In some embodiments, the cap 600 and the base 604 forming the personalized earphone unit parts or shells having pins 610 protruding out from the cap 600 and the base 604, which is printed using the at least one three dimensional printing unit 112 associated with the computer implemented system 100 for producing the personalized earphone unit 114. The personalized earphone unit shells formed by assembling the 3D printed interchangeable unique bezel 602, the cap 600 and the base 604 forms the structure of the personalized earphone unit 114. The plurality of 3D printed personalized earphone unit shells allows the insertion of the plurality of electronic components to assemble the personalized earphone units 114. FIG. 17 shows an assembled view of the personalized earphone unit 114 made from 3D printed interchangeable unique bezel 602, the cap 600 and the base 604. The personalized earphone unit 114 is tethered to provide audio signals to the plurality of electronic components secured inside the cavity formed by the 3d printed cap 600 and the base 604. The wires 608 are connected to the plurality of electronic components and brought out for connecting to an audio device. The ends of the wires 608 may be connected to an audio jack or pin for connecting to the plurality of electronic communication devices.

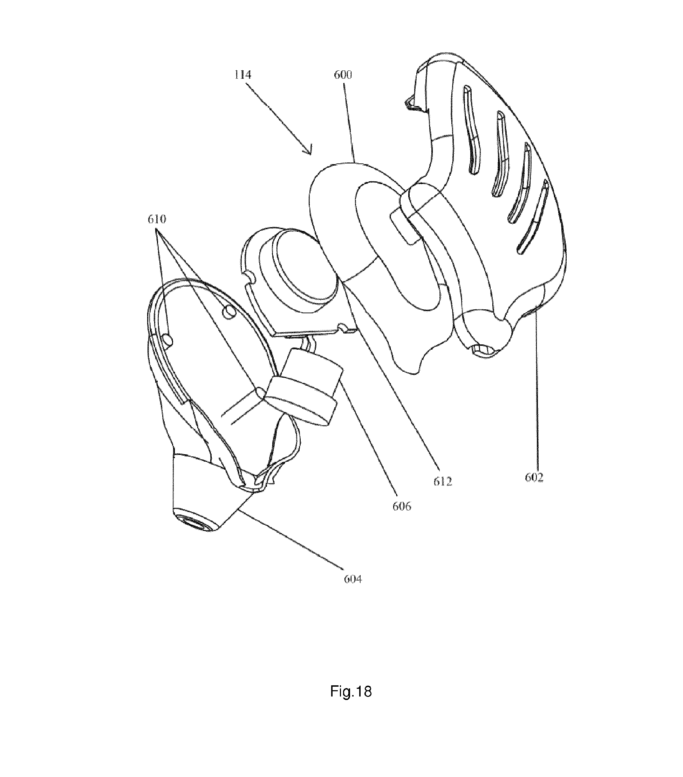

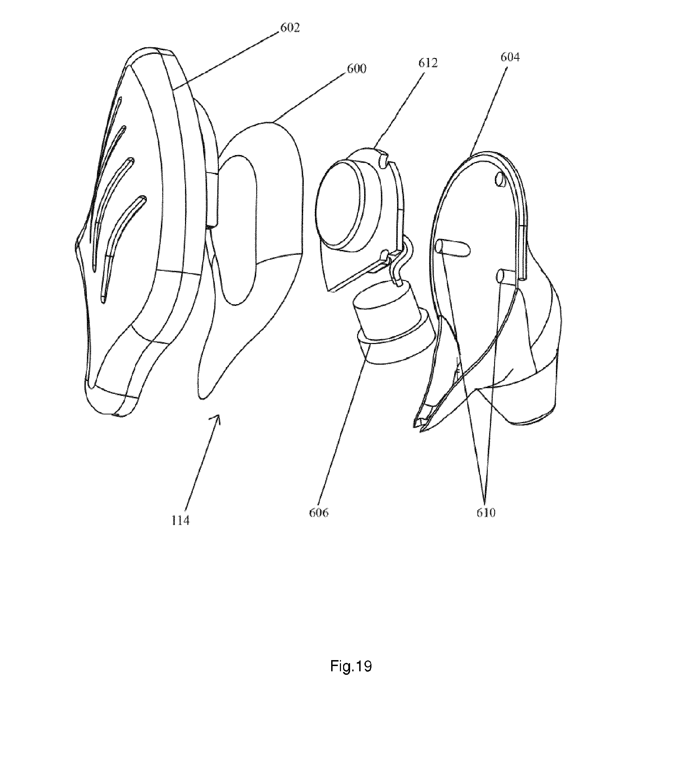

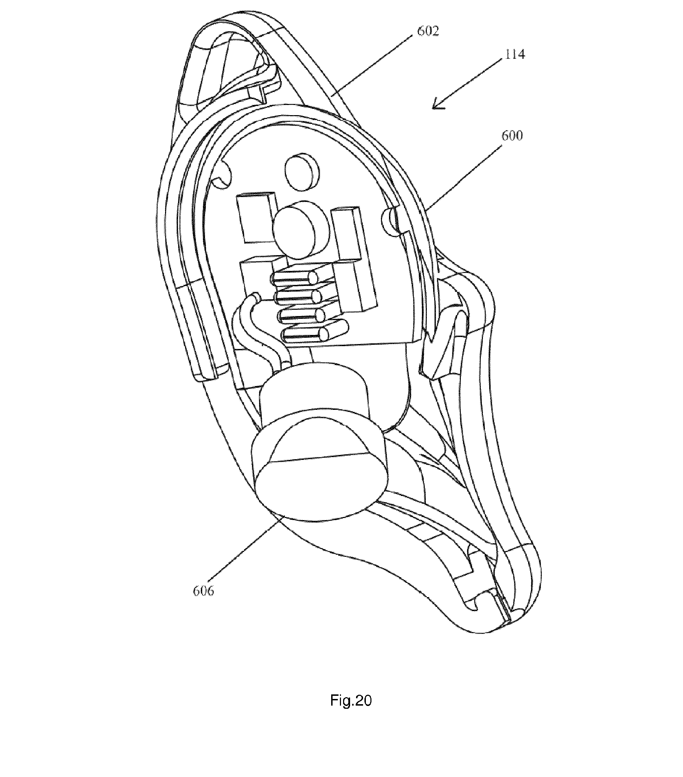

FIG. 18 and FIG. 19 shows an exploded view of the personalized earphone unit 114 showing a plurality of 3d printed parts, such as the interchangeable unique bezel 602, the cap 600 and the base 604, which are printed using the three-dimensional printer unit 112, and the plurality of audio electronic components of the wired or wireless personalized earphone unit 114. The plurality of audio electronic components of the wired or wireless personalized earphone unit 114 includes at least one battery for enabling the earphone unit 114 for wireless operation. Here the plurality of electronic components and the battery may be bundled as a single package 612 and securely arranged at the predetermined position inside the cap 600 and the base 604. The personalized earphone unit 114 with built in battery with the plurality of audio electronic components connected to the speaker 606 allows for wireless operation of the earphone unit 114 using Bluetooth. The inner side of the personalized earphone unit 114 with the cap 600 and the base 604 may include elements to fix the electronics components in predetermined places. Several methods are employed to allow strong and fast assembly between the plurality of plurality of 3d printed parts, such as the interchangeable unique bezel 602, the cap 600 and the base 604, to create the personalized earphone unit 114. Those methods for assembling the personalized earphone unit 114 from the plurality of 3d printed parts includes mechanical joints and various attachment mechanisms such as, but not limited to, pins, holes systems, snap system, rivets, and dovetail joints etc. FIG. 20 shows the plurality of audio electronic components with the battery placed inside the single package 612 for the personalized earphone unit 114 made from the 3d printed parts. Here the methods may utilize adhesive to strengthen the assembly. The electronic components package 612 may include the plurality of audio electronic components fabricated on to a circuit board or the plurality of audio electronic components securely positioned inside the package 612 by gluing them to the package 612.

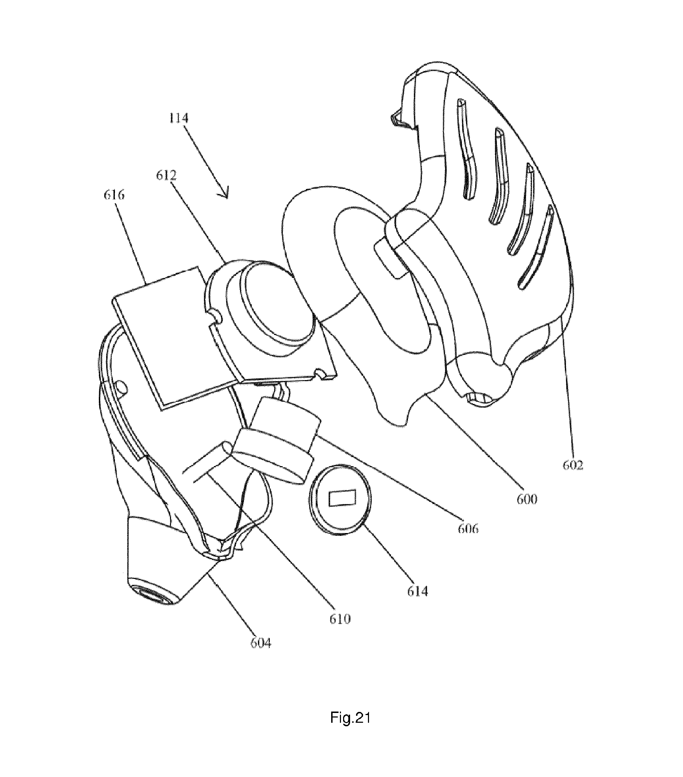

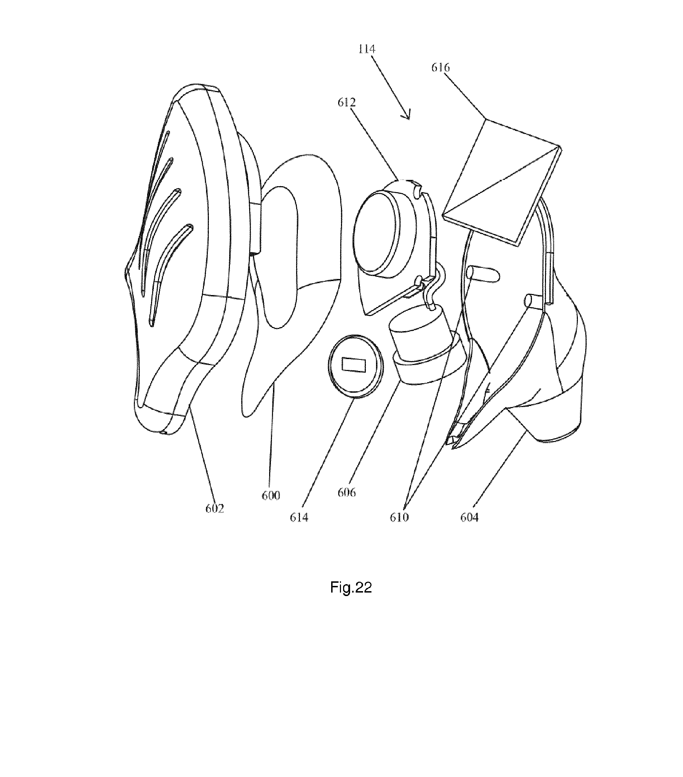

FIG. 21 and FIG. 22 shows an exploded view of the personalized earphone unit 114 showing a plurality of 3d printed parts, such as the interchangeable unique bezel 602, the cap 600 and the base 604, which are printed using the three-dimensional printer unit 112, and the electronic components package 612 having the plurality of audio electronic components of the wired or wireless personalized earphone unit 114, at least one sensor 614 and a microcontroller 616 securely positioned between the bezel 602 and the cap 600. The sensors 614 positioned inside the personalized earphone unit 114 may be utilized for sensing a plurality of information such as environmental sounds. The information collected by the sensors 614 may be transferred to the microcontroller 616 positioned inside the cavity between the cap 600 and the base 604 for further processing. The microcontroller 616 may generates signal by analyzing the plurality of data received from the sensors 614 and may signal the plurality of electronic components for real-time control of the audio generated by the earphone unit 114. In some embodiments, the sensors 614 may include, but not limited to, humidity, pressure, temperature sensors for measuring a plurality of physical parameters such as humidity, pressure, temperature, etc. In some embodiments, the sensors 614 may measure user body information such as heartbeat, blood pressure, body temperature, etc. and the data may be processed by the microcontroller 616 and may be send to an application running on any electronic communication devices such as smartphone, smart watch etc. for real-time monitoring and analysis. The microcontroller 616 can also be used to control different parameters such as, but not limited to immersion level, real-world notifications etc. The microcontroller 616 may process the real-time data and may control the various audio electronic components in the earphone unit 114 to deliver a desired audio output set by the user using the mobile application 108.

At least one automated or a manual assembly system may be utilized to enable assembly of the personalized earphone unit parts that are printed in different 3D printers and/or for assembling with adds-on, for example, an assembly of a back part printed with FDM printer with a metal front. The back offers a durable and affordable material, while the front offers the metal look. The personalized earphone unit shells formed by the 3D printed parts such as interchangeable unique bezel 602, the cap 600 and the base 604 may be assembled as described above. The process also allows incorporating a plurality of components or parts printed using different 3D printers with the personalized earphone unit 114. Elements like logos, letters, lines, abstract shapes, could be printed from a different material than the shell i.e. metal, ceramic, ABS and assembled into shell, through methods such as, but not limited to, PAD printing. The design of the personalized earphone unit shells includes a depression in the area of the element, in order to fit elements like logos, letters, lines, abstract shapes and the plurality of add-ons into the personalized earphone unit shells. In certain designs, the personalized earphone unit shells may have a hole instead of the depression, and the elements like logos, letters, lines, abstract shapes and the plurality of add-ons may be placed inside the shell. The hole in the personalized earphone unit shells may expose the elements like logos, letters, lines, abstract shapes and the plurality of add-ons to allow its visibility, while in the inner side, a dovetail joints or a tongue and groove system may allow placing the element in place. The computer implemented system 100 for producing the personalized earphone units 114 also allow the user to incorporate add-on such as LED or design elements such as gemstones. The personalized earphone unit shells may be printed with sockets to enable quick and strong assembly into those shells. In some cases, a back part of the model utilizing SLA or DSP printer system may be used for the personalized earphone unit shells. In some instances, the personalized earphone unit shells such as the cap 600 and the base 604 and the bezel 602 may include a multi-material system having a combination of materials with different elasticity for use in the same or different parts of the personalized earphone unit shells or in the add-ons. A combination of at least three materials for printing of the personalized earphone unit shells or add-ons and another material for support, which may provide strength and durability to the personalized earphone unit shells can be used. In some instances, the plurality of personalized earphone unit shells is subjected to post processing methods such as coating with specialized materials for enhanced durability and stability of the personalized earphone unit 114. In some cases, tooling processes is employed to print the personalized earphone unit 114 from the personalized earphone unit shells. In this process the personalized earphone unit shells such as the cap 600 and the base 604 are printed as two parts such as a male and female parts from desired materials such as cast silicon and the male and female parts are stamped together with the plurality of audio electronic components inside to form the personalized earphone unit 114. The process may map the 3D earphone model into dozens of area, which may assign a different elasticity level to the personalized earphone unit 114. The cap 600 and the base 604 of the personalized earphone unit 114 are designed to fit securely together to form the personalized earphone unit 114. In some instances, the process allows to pair a metal front personalized earphone unit shell i.e. the cap 600, or front part made from any other printable material with a back personalized earphone unit shells i.e. the base 604 or back part of same material or different material. In some embodiments, the users can opt to design black or white personalized earphone unit shells using the computer-implemented system 100 for producing the personalized earphone units 114 of the present invention. The users can then customize or paint or decorate the white personalized earphone unit shells such as the interchangeable unique bezel 602, the cap 600 and the base 604 with his/her desired color. For example, the users can paint the 3d printed personalized earphone unit shells to match with his/her nail polish thereby matching with the user's nails.

In some embodiments, the website or mobile application 108 of the computer implemented system 100 for producing the personalized earphone units 114 is able to run on variety of devices, such as mobile platforms, gaming consoles, desktop computers etc. The website may have the same functionalities as the mobile application 108. For supported platforms such as iMac, etc. the website may allow a scanning module. The website may allow the user to log-in to his/her account and view the marketplace as described above. The mobile application 108 or website may allow the user to simulate how the earphones may look on his/her ears through an augmented reality model capable of being launched from the variety of devices, such as mobile platforms, gaming consoles, desktop computers etc. The website includes shopping cart and checkout section similar to the mobile application 108. Preferences and/or choices of the user, such as, but not limited to, style and design preferences, interaction with other users through the mobile application 108 or the website may be saved under the user profile, and could be accessed through any electronic device having internet connectivity. The website or mobile application 108 allow the users to share their favorite designs, design they just created, purchased product and any other activity on the platform through social networks. This integration may allow to the user to view his/her friends' activity when he/she logs in to the platform, and content may be displayed according to the user's preferences and demographics such as the most liked designs, popular styles in a particular city, college, social network group, etc. For example, the most popular designs by fans of a certain group, or most popular designs by students at a certain school, can be displayed.

The mobile application 108 includes the augmented Soundscaping module, which can act as an app for the user's playing device to adjust his/her Soundscape in real-time. FIG. 11C and FIG. 11D illustrates screen shots of a user interface of the mobile application 108 showing a plurality of real world notifications, from which the user can select the real world notifications that can be let into the user's music by adjusting from the user interface of the mobile application 108. The mobile application 108 may support mobile platforms, gaming consoles, desktop computers etc. The device should have a microphone, or be able to connect to one. Alternatively the earphone should include a microphone for the app to be able to run. In certain cases the earphones may have two microphones, one may be an Omni microphone to pick up environmental sound, and the other may be a directional microphone to pick up sounds that are coming in front of the user (for example, conversation with another person. The sound from the Omni microphone may be deducted from the directional microphone to provide a clearer sound. The user interface of the mobile application 108 may let the user choose specific sounds that may be augmented to the user's sound as shown in FIG. 11C. In situation when the user is interested in letting Real World Notification such as police siren, knock on the door, fire alarm, buzz on the door, vehicle horns, to be added to his/her music. The user can add preconfigured elements that may be detected by the app, and overlaid into his/her music. The mobile application 108 may use the microphone to consistently listen to the environmental sound. If a sound in the environment matches a sound that the user chose, this sound may be added to the sounds sent from the device to the earphone. In that case, the user can block the constant environmental sound such as airplane noise through the physical seal in the earphone to the ear-canal, but still be allowed to have certain sounds elements to come through. For example, if the user wants to let in the sound of 'train stop' then he/she may select 'train stop' from the user interface of the mobile application 108 as in FIG. 11D. User can also record his/her own sounds and add them to the list of sounds for letting in or letting out, such as own door buzzer, a specific subway system notification sound, airport notification sounds, dog barking, baby crying etc. The user can share those sounds, and have them geo tagged, for example. Users may be able to listen the sounds shared by other users at a specific location. In addition, the user may be able to turn on geo tagged awareness and their soundscape may add real world sound notification according to previously recorded sounds by other users.

In some embodiments of the present invention, the audio signal generating electronic components of the personalized earphone unit 114 includes hearing aid electronics for hearing impaired persons. These persons can wear the personalized earphone unit 114 inside or around their ears, depending upon the type of the personalized earphone unit 114 printed by the three dimensional printer unit 112. Since the personalized earphone unit 114 is custom designed for individuals who need a secure fitting ear piece, users can easily use the personalized earphone unit 114 to listen to music while performing activities, such as running, riding, hiking etc. Since the personalized earphone unit 114 is custom made according to the shape of ears of an individual user, it won't accidentally fall of while performing activities, such as running, riding, hiking etc. Moreover, the user of the personalized earphone unit 114 can choose the material used for the personalized earphone unit 114 such as plastic, rubber-like material or metal or combination of material, what sometime called "digital material". The user could choose what areas of the earphone may be made out of rigid, or soft, rubber like material. The user can also choose the outside appearance of the personalized earphone unit 114, i.e. the color and the graphics on the personalized earphone unit 114 and the level of fitting to the ear he or she desires i.e. tight, normal or loose. The user can also choose the type of the personalized earphone unit 114 such as wired/wireless device, In-ear earphone, on-ear earphones, Ear-buds, Ear-buds with clip on, Personal monitor, headset (speaker and microphone) and wired/wireless add-ons to use with a mobile device, or earplugs. The In-ear earphone is fitted to the ear canal, providing isolation from outside noise. The in-ear earphone is a means to direct sound into the ear canal while isolating the sound source from any microphones and amplification electronics. Such in-ear audio coupling devices therefore often utilize an "acoustic seal" which is created by the custom made personalized earphone unit 114. Whereas the Ear-buds are very small headphones that are fitted directly in the outer ear, facing but not inserted in the ear canal. The Personal monitor is a larger headpiece that enters the ear canal, and fitted to the acoustic meatus for anchoring the ear piece during activity. Ear-buds with clip on are a fitted clip that sit in the bowl of the ear and use the ridge of your ear for added support.

Although the present technology has been described in detail for the purpose of illustration based on what is currently considered to be the most practical and preferred implementations, it is to be understood that such detail is solely for that purpose and that the technology is not limited to the disclosed implementations, but, on the contrary, is intended to cover modifications and equivalent arrangements that are within the spirit and scope of the appended claims. For example, it is to be understood that the present technology contemplates that, to the extent possible, one or more features of any implementation can be combined with one or more features of any other implementation.

In this document, the terms "a" or "an" are used, as is common in patent documents, to include one or more than one. In this document, the term "or" is used to refer to a nonexclusive "or," such that "A or B" includes "A but not B," "B but not A," and "A and B," unless otherwise indicated. Furthermore, all publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

The description provided herein is complete and sufficient for those skilled in the arts of systems, mobile application development and web development to implement the methods as described. Some embodiments of this computer assisted system for producing personalized earphone units may employ a server running an operating system such as Windows, Linux, web-server software such as Apache, and database such as MySQL, with methods implemented through a software development language such as PHP or Java. However, the invention should not be limited to these types of software operating system, web-server software, database software, software development language, server or client hardware.

## Claims

1. A system configured to facilitate fabrication of a personalized earphone, the system comprising:
one or more physical computer processors configured, by computer readable instructions, to:
obtain visual information recorded by a visual data device, the visual information representing physical geometry of an ear of a subject;
determine a model of the ear of the subject based on the visual information, the model describing dimensional parameters of the ear in three dimensions;
based on the model of the ear of the subject, generate a corresponding model of a personalized earphone configured to be worn in the ear of the subject; and
generate an electronic file from the model of the personalized earphone configured to be utilized to inform a three dimensional printing device that fabricates the personalized earphone for the subject.

2. The system of claim 1, wherein the one or more physical computer processors are further configured to effectuate presentation of a graphical user interface configured to facilitate at least one of: entry and/or selection of information from the subject, display information to the subject via a client computing device associated with the subject, enable customization of the model of the personalized earphone.

3. The system of claim 2, wherein the one or more physical computer processors are configured such that customization includes one or more of adjusting geometry of the earphone, adjusting a color of the earphone, adjusting a material that forms the earphone, adjusting ergonomic options associated with the earphone, adjusting soundscaping options associated with the earphone, or choosing add-ons for the earphone.

4. The system of claim 2, wherein the one or more physical computer processors are configured to electronically store one or more of the visual information, the model of the ear of the subject, the model of the personalized earphone, the electronic file, or the customized model of the personalized earphone in an electronic user profile associated with the subject.

5. The system of claim 2, wherein the one or more physical computer processors are configured to facilitate one or more of sharing, marketing, or selling of customized models of personalized earphones among users.

6. The system of claim 2, wherein the one or more physical computer processors are configured such that the client computing device includes one or more of a desktop computer, a laptop computer, a tablet computer, or a smart phone with the visual data device that includes a digital camera, a video camera, an infrared camera, an optical scanner, or an ultrasound device.

7. The system of claim 1, wherein the one or more physical computer processors are configured such that causing the visual data device to obtain the visual information that represents the physical geometry of the ear of the subject relative to the reference object includes prompting the subject to position the reference object near the ear, the prompting performed via a graphical user interface presented to the subject on a smartphone associated with the subject.

8. The system of claim 1, wherein the one or more physical computer processors are configured to determine the model of the ear of the subject based on the visual information using photogrammetry.

9. The system of claim 1, wherein the one or more physical computer processors comprise one or more first processors that are included with the visual data device in a smartphone associated with the subject, and one or more second processors included in a remotely located server,
the first processors configured to:
obtain the visual information recorded by the visual data device that represents the physical geometry of the ear of the subject;
determine whether the visual information is sufficient to generate the model of the ear of the subject; and
responsive to the visual information being sufficient, wirelessly communicate the visual information to the second processors;
the second processors configured to:
determine the model of the ear of the subject;
based on the model of the ear of the subject, generate the corresponding model of the personalized earphone configured to be worn in the ear of the subject; and
generate the electronic file from the model of the personalized earphone.

10. A system configured to facilitate fabrication of a three dimensional printing object configured to removably couple with a body part of a subject, the system comprising:
one or more physical computer processors configured, by computer readable instructions, to:
obtain visual information recorded by a visual data device, the visual information representing physical geometry of the body part of the subject;
determine a model of the body part of the subject based on the visual information, the model describing dimensional parameters of the body part in three dimensions;
based on the model of the body part of the subject, generate a corresponding model of a personalized three dimensional printing object configured to removably couple with the body part of the subject; and
generate an electronic file from the model of the body part configured to be utilized to inform a three dimensional printing device that fabricates the three dimensional printing object for the subject.

11. A method for facilitating fabrication of a personalized earphone, the method comprising:
obtaining visual information recorded by a visual data device, the visual information representing physical geometry of an ear of a subject;
determining a model of the ear of the subject based on the visual information, the model describing dimensional parameters of the ear in three dimensions;
based on the model of the ear of the subject, generating a corresponding model of a personalized earphone configured to be worn in the ear of the subject; and
generating an electronic file from the model of the personalized earphone configured to be utilized to inform a three dimensional printing device that fabricates the personalized earphone for the subject.

12. The method of claim 11, further comprising effectuating presentation of a graphical user interface configured to facilitate at least one of: entry and/or selection of information from the subject, display information to the subject via a client computing device associated with the subject, enable customization of the model of the personalized earphone.

13. The method of claim 12, wherein customization of the model of the personalized earphone includes one or more of adjusting geometry of the earphone, adjusting a color of the earphone, adjusting a material that forms the earphone, adjusting ergonomic options associated with the earphone, adjusting soundscaping options associated with the earphone, or choosing add-ons for the earphone.

14. The method of claim 11, further comprising electronically storing one or more of the visual information, the model of the ear of the subject, the model of the personalized earphone, the electronic file, or the customized model of the personalized earphone in an electronic user profile associated with the subject.

15. The method of claim 12, further comprising facilitating one or more of sharing, marketing, or selling of customized models of personalized earphones among users.

16. The method of claim 12, wherein the client computing device includes one or more of a desktop computer, a laptop computer, a tablet computer, or a smart phone with the visual data device that includes a digital camera, a video camera, an infrared camera, an optical scanner, or an ultrasound device..

17. The method of claim11, wherein causing the visual data device to obtain the visual information that represents the physical geometry of the ear of the subject relative to the reference object includes prompting the subject to position the reference object near the ear, the prompting performed via a graphical user interface presented to the subject on a smartphone associated with the subject.

18. The method of claim 11, further comprising determining the model of the ear of the subject based on the visual information using photogrammetry.

19. The method of claim 11, further comprising including one or more first processors with the visual data device in a smartphone associated with the subject, and including one or more second processors in a remotely located server,
wherein the first processors are configured to:
obtain the visual information recorded by the visual data device that represents the physical geometry of the ear of the subject;
determine whether the visual information is sufficient to generate the model of the ear of the subject; and
responsive to the visual information being sufficient, wirelessly communicate the visual information to the second processors; and
wherein the second processors configured to:
determine the model of the ear of the subject;
based on the model of the ear of the subject, generate the corresponding model of the personalized earphone configured to be worn in the ear of the subject; and
generate the electronic file from the model of the personalized earphone.
